# EUROPEAN PATENT SPECIFICATION

(11) **EP 3 460 861 B1**
(45) Date of publication and mention of the grant of the patent: **01.03.2023**
(21) Application number: 18195571.7
(22) Date of filing: 19.09.2018
(51) Int. Cl.: H01L 33/62, H01L 25/075

(54) **DISPLAY DEVICE**
ANZEIGEVORRICHTUNG
AFFICHEUR

(30) Priority: 21.09.2017 US 201762561220 P; 20.12.2017 US 201762608004 P; 17.04.2018 CN 201810342285
(43) Date of publication of application: 27.03.2019
(73) Proprietor: InnoLux Corporation, Chu-Nan, Miao-Li 350 (TW)
(72) Inventor: CHU, Wei-Cheng, 350 Miao-Li County (TW); JIANG, Ming-Fu, 350 Miao-Li County (TW); LIU, Chia-Cheng, 350 Miao-Li County (TW); HU, Shun-Yuan, 350 Miao-Li County (TW); CHAO, Ming-I, 350 Miao-Li County (TW)
(74) Representative: 2K Patentanwälte Blasberg Kewitz & Reichel

(56) References cited:
- EP-A1- 2 455 435
- EP-A1- 2 610 926
- EP-A1- 2 960 312
- EP-A1- 2 963 693
- EP-A1- 2 996 164
- EP-A2- 3 352 217
- EP-A2- 3 410 480
- WO-A1-2015/026033
- WO-A1-2016/161161
- WO-A1-2017/146493
- US-A1- 2011 215 349
- US-A1- 2016 254 244

## Description

### BACKGROUND

### Technical Field

The present invention relates to display devices, and in particular to display devices that include light-emitting diodes.

### Description of the Related Art

As digital technology develops, display devices are being used more widely in our society. For example, display devices have been applied in modem information and communication devices such as televisions, notebooks, computers, and mobile phones (e.g., smartphones). In addition, each generation of display devices has been developed to be thinner, lighter, smaller, and more fashionable than the previous generation.

Among the various types of display devices available, light-emitting diode (LED) display devices are gaining in popularity, since LEDs have such advantages as high efficiency and a long life span.

WO 2015/026033 A1 discloses a display device including a lower substrate disposed with a line electrode at an upper portion thereof, a plurality of semiconductor light emitting devices electrically connected to the line electrode to generate light, a wavelength converter disposed on the semiconductor light emitting device to convert a wavelength of light generated from the semiconductor light emitting device, and a conductive adhesive layer comprising conductors configured to electrically connect the lower substrate to the semiconductor light emitting device and a body configured to surround the conductors, wherein the semiconductor light emitting device has a composition formula of InxAlyGa1-x-yN (0≤x≤1, 0≤y≤1, 0≤x+y≤1).

EP 3 352 217 A2 discloses a display device including a thin-film transistor substrate, a conductive pad disposed on the thin-film transistor substrate, and an adhesion film disposed on the conductive pad. The adhesion film includes a plurality of conductive particles. The display device also includes a light-emitting component disposed on the adhesion film. The light-emitting component includes a connection feature. The display device also includes a protection layer partially surrounding the light-emitting component. The connection feature of the light-emitting component has a lower portion not surrounded by the protection layer. The adhesion film has a thickness of T, one of the plurality of conductive particles has a diameter of d, the lower portion of the connection feature has a thickness of t, and 0.

EP 3 410 480 A2 discloses a display device including a substrate, and a light-emitting unit disposed on the substrate. The light-emitting unit includes a first conductive layer overlapping a second conductive layer, a first semiconductor layer disposed between the first conductive layer and the second conductive layer, a second semiconductor layer disposed between the first semiconductor layer and the first conductive layer, a quantum well structure disposed between the first semiconductor layer and the second semiconductor layer, and a via hole penetrated through the first semiconductor layer and the quantum well structure. The second conductive layer is electrically connected with the second semiconductor layer through a conductive material disposed in the via hole.

WO 2017/146493 A1 discloses a light-emitting element package and a display device. The light-emitting element package comprises: a substrate; a first light-emitting element disposed on the substrate and emitting a red wavelength light; a second light-emitting element disposed parallel with the first light-emitting element in a first direction and emitting a blue or green wavelength light; a third light-emitting element disposed parallel with the first and second light-emitting elements in a second direction that is orthogonal to the first direction and emitting a green or blue wavelength light; and a molding part covering the first to third light-emitting elements, wherein a first upper electrode connected to the first light-emitting element, a second upper electrode connected to the second light-emitting element, a third upper electrode connected to the third light-emitting element, and a fourth upper electrode commonly connected to the first to third light-emitting elements are included on the substrate, the first to third light-emitting elements are arranged to be misaligned in the first direction, and the centers of the first to third light-emitting elements can be arranged within a curvature range having a curvature radius of 250 µm from the center of the substrate. The light-emitting element package according to the embodiment can provide full colors, implement uniform color and uniform brightness, and increase a bonding force between the molding part and the substrate. In the embodiment, a configuration can be simplified and slimness can be implemented.

EP 2 963 693 A1 discloses a A light emitting diode device comprising a substrate, a plurality of metal pads, a plurality of LEDs and a first metal conductive wire. The substrate has a first surface, a second surface disposed opposite to the first surface and a plurality of vias disposed between the first surface and the second surface. A plurality of first metal pads of the metal pads are disposed on the first surface of the substrate, and the LEDs are disposed on a part of the first metal pads. Each of the LEDs has at least one first electrode contact. The first electrode contact of each of the LEDs electrically connected to the first metal conductive wire has the same electrode contact polarity. Moreover, another light emitting diode device is also provided.

WO 2016/161161 A1 discloses solid state lighting apparatuses, systems, and related methods. An example apparatus can include one or more light emitting diodes (LEDs) and a dark or black encapsulation layer surrounding and/or disposed between the one or more LEDs. The apparatus can include, e.g., a substrate or a leadframe for mounting the LEDs. A method for producing a panel of LEDs can include joining the LEDs to the panel, e.g., by bump bonding, and flooding the panel with dark or black encapsulation material so that the LED chips are surrounded by the dark or black encapsulation material.

However, existing LED display devices have not been satisfactory in every respect.

### BRIEF SUMMARY

The present invention provides a display device according to claim 1.

In some embodiments of the present invention a conductive adhesive layer is disposed between the substrate and the light-emitting diodes. The conductive adhesive layer includes at least one of In, Ag, or Sn.

A detailed description is given in the following embodiments with reference to the accompanying drawings.

### BRIEF DESCRIPTION OF THE DRAWINGS

The present invention can be more fully understood from the following detailed description when read with the accompanying figures. It is worth noting that in accordance with standard practice in the industry, various features are not drawn to scale. In fact, the dimensions of the various features may be arbitrarily increased or reduced for clarity of discussion.

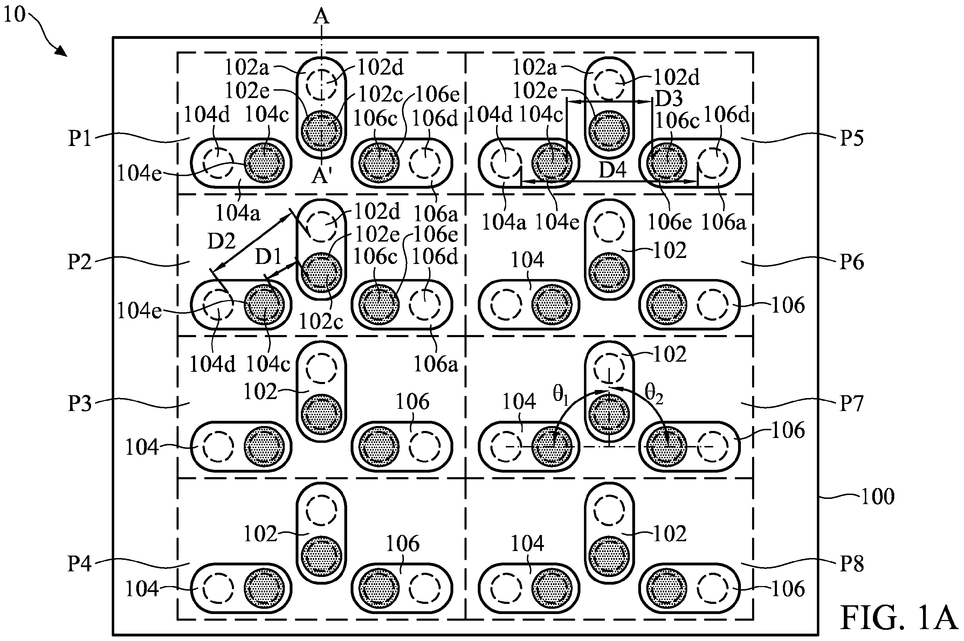

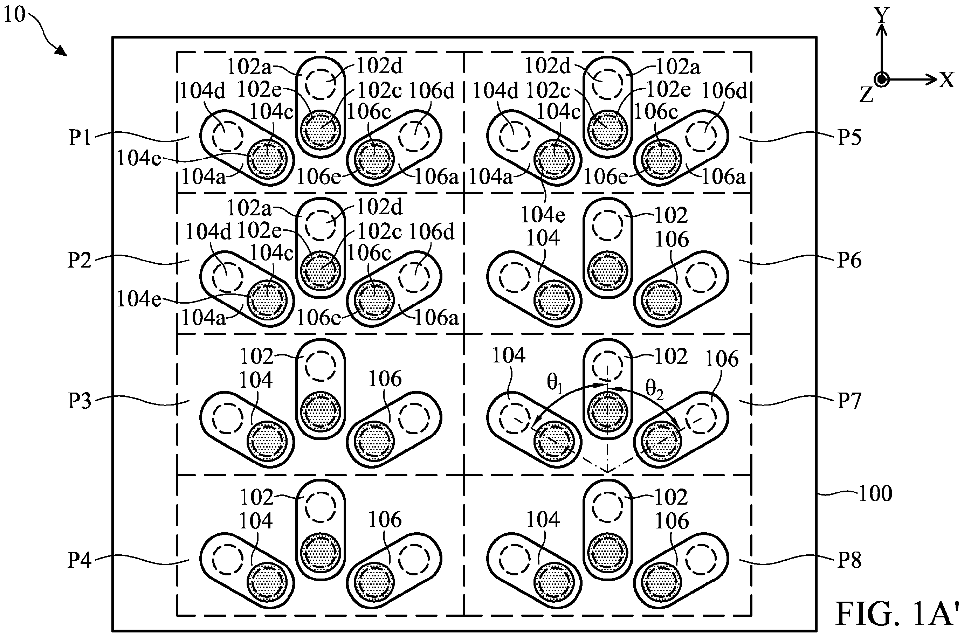

FIG. 1A illustrates a top view of the display device 10 according to an example not forming part of the present invention.
FIG. 1A' illustrates a top view of the display device 10 according to an example not forming part of the present invention.
FIG. 1B illustrates a cross-sectional view of the display device 10 along the cut line A-A' of FIG. 1A.
FIG. 1C illustrates a top view of the substrate 100 of the display device 10 according to an example not forming part of the present invention.
FIG. 2 illustrates a top view of the display device 10 according to an example not forming part of the present invention.
FIG. 3A illustrates a top view of the display device 30 according to an example not forming part of the present invention.
FIG. 3B illustrates a cross-sectional view of the display device 30 along the cut line D-D' of FIG. 3A.
FIG. 4A illustrates a top view of the display device 40 according to an example not forming part of the present invention.
FIG. 4B illustrates a cross-sectional view of the display device 40 along the cut line E-E' of FIG. 4A.
FIG. 5 illustrates a top view of the display device 50 according to an embodiment of the present invention.
FIG. 6A illustrates a cross-sectional view of the light-emitting diode 602 according to some embodiments of the present invention.
FIG. 6B illustrates a top view of the light-emitting diode 602 according to some embodiments of the present invention.
FIG. 6C illustrates a top view of the light-emitting diode 602 according to some embodiments of the present invention.
FIG. 6D illustrates a top view of the light-emitting diode 602 according to some embodiments of the present invention.
FIG. 6E illustrates a top view of the light-emitting diode 602 according to some embodiments of the present invention.
FIG. 6F illustrates a top view of the light-emitting diode 602 according to some embodiments of the present invention.
FIGS. 7A, 7B, and 7C are a series of cross-sectional views illustrating a method for forming display devices according to an example not forming part of the present invention.
FIG. 8 illustrates a cross-sectional view of the display device 70 according to some embodiments of the present invention.
FIG. 9A illustrates a process perspective view of a method for forming display devices according to an example not forming part of the present invention.
FIGS. 9B and 9C are a series of cross-sectional views illustrating a method for forming display devices according to an example not forming part of the present invention.
FIGS. 10A, 10B, 10C, 10D, 10E, and 10F are a series of cross-sectional views illustrating a method for forming display devices according to an example not forming part of the present invention.

### DETAILED DESCRIPTION

The following detailed description provides different embodiments for implementing the present invention. Specific components and arrangements are described below. These are, of course, not intended to be limiting. For example, the formation of a first feature over or on a second feature in the description that follows may include embodiments in which the first and second features are formed in direct contact, and may also include embodiments in which additional features may be formed between the first and second features, such that the first and second features may not be in direct contact.

In addition, the detailed description may repeat reference numerals and/or letters in the various embodiments. This repetition is for simplicity and clarity and does not in itself dictate a relationship between the various embodiments and/or configurations discussed.

Additional operations may be provided before, during, and/or after the steps described in these embodiments. Some of the steps described may be replaced or omitted in different embodiments. In addition, although some embodiments of the present invention will be discussed in the following paragraphs with several steps in a specific order, these steps may be performed in other reasonable orders.

Example 1, not forming part of the present invention.

The arrangement of the light-emitting diodes of the display device of Example 1 may increase the contrast ratio of the display device, and the details will be discussed in the following paragraphs.

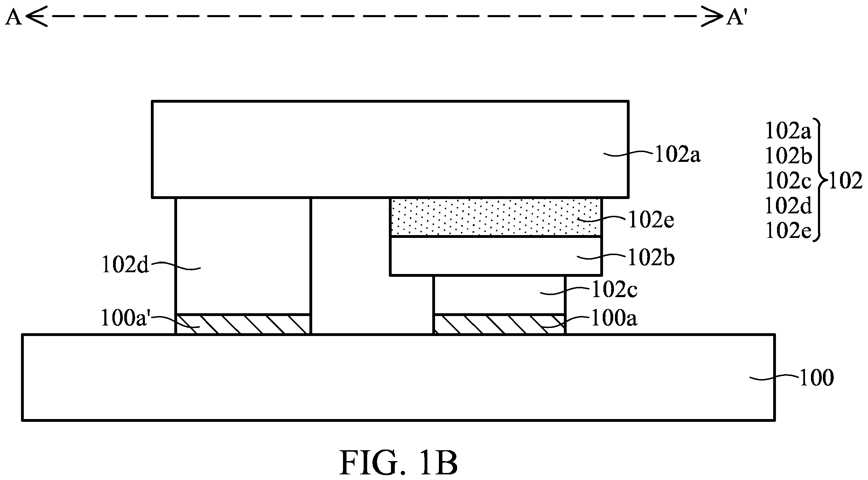

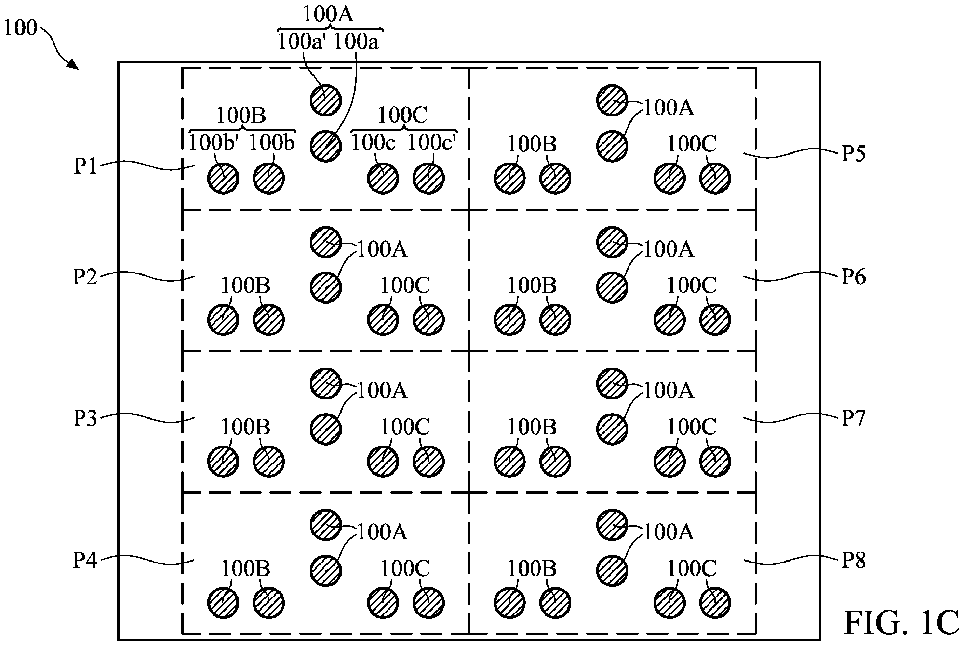

FIG. 1A illustrates a top view of the display device 10 of the present example. FIG. 1B illustrates a cross-sectional view of the display device 10 along the cut line A-A' of FIG. 1A, and FIG. 1C illustrates a top view of the substrate 100 of the display device 10.

As shown in FIG. 1A, in some embodiments, the display device 10 may have a plurality of pixels (e.g., pixels P1, P2, P3, P4, P5, P6, P7, and P8). It should be understood that the pixels of the display device 10 may have the same or similar features to each other (e.g., the pixels may include the same or similar elements, and these elements may be disposed in the same or similar way). Therefore, unless otherwise specified, features described in the following paragraphs with respect to a particular pixel of the display device 10 may also be included in any other pixels of the display device 10. In addition, it should be understood that although only eight pixels (i.e., pixels P1, P2, P3, P4, P5, P6, P7, and P8) are shown in FIG. 1A, the present disclosure is not limited thereto. The display device may have any other applicable number of pixels according to design requirements.

Still referring to FIG. 1A, a pixel (e.g., pixels P1, P2, P3, P4, P5, P6, P7, and P8) of the display device 10 may correspond to or include at least a light-emitting diode. In other words, there is at least a light-emitting portion of a light-emitting diode in a pixel of the display device 10. For example, in some embodiments, as shown in FIG. 1A, each of the pixels P1, P2, P3, P4, P5, P6, P7, and P8 corresponds to or includes three light-emitting diodes (i.e., a light-emitting diode 102, a light-emitting diode 104, and a light-emitting diode 106), but the present disclosure is not limited thereto. In some other embodiments, a pixel may correspond to or include any other applicable number of light-emitting diodes according to the design requirements. In some embodiments, the light-emitting diodes discussed above may be organic light-emitting diodes (OLEDs), Mini-LEDs, Micro-LEDs, or Quantum-dot LEDs, but the present disclosure is not limited thereto.

Now referring to FIG. 1B, the light-emitting diode 102 may include a semiconductor layer 102a and a semiconductor layer 102b vertically stacked on each other, a light-emitting portion 102e disposed between the semiconductor layer 102a and the semiconductor layer 102b, a conductive pad 102c and a conductive pad 102d disposed between the semiconductor layer 102a and a substrate 100 of the display device 10. In some embodiments, as shown in FIG. 1B, the conductive pad 102c and the conductive pad 102d may be adjacent to each other, and the light-emitting portion 102e may be located on the conductive pad 102c. In some embodiments, the light-emitting portion 102e may not be located on the conductive pad 102c, but the present disclosure is not limited thereto. In some embodiments, the location of the semiconductor layer 102b and the location of the conductive pad 102c may correspond to the location of the light-emitting portion 102e. In other words, in these embodiments, in the top view of FIG. 1A, the semiconductor layer 102b and the conductive pad 102c at least partially overlap the light-emitting portion 102e. In an embodiment, the substrate 100 may include a hard substrate, a flexible substrate, other applicable substrates, or a combination thereof. For example, the hard substrate may be made of glass, the flexible substrate may be made of polyimide (PI) or polyethylene terephthalate (PET), but the present disclosure is not limited thereto. In some other embodiments, the hard substrate or the flexible substrate may be made of any other applicable materials. In some embodiments, the substrate 100 may be a transparent substrate, but the present disclosure is not limited thereto. In some other embodiments, the substrate 100 may be an opaque substrate.

For example, each of the semiconductor layer 102a and the semiconductor layer 102b may be made of GaN, AlGaN, AlN, GaAs, GaInP, AlGaAs, InP, InAlAs, InGaAs, AlGaInP, other applicable III-V group semiconductor materials, or a combination thereof, but the present disclosure is not limited thereto. The light-emitting portion 102e may be made of GaN, AlGaN, AlN, GaAs, GaInP, AlGaAs, InP, InAlAs, InGaAs, AlGaInP, other applicable III-V group semiconductor materials, or a combination thereof, but the present disclosure is not limited thereto. In some embodiments, the light-emitting portion 102e may include a quantum well structure. In some embodiments, the recombination rate of the electrons and the holes in the quantum well structure discussed above is high, thus increasing the light-emitting efficiency of the display device 10.

For example, an epitaxial process may be used to form the semiconductor layer 102a, the light-emitting portion 102e and the semiconductor layer 102b on an applicable epitaxial substrate (not shown in the figures), and the epitaxial substrate may be removed after the light-emitting diode 102 is bonded onto the substrate 100. For example, the epitaxial substrate may include sapphire substrate, SiC substrate, Si substrate, MgAl₂O₄ substrate, MgO substrate, LiAlO₂ substrate, LiGaO₂ substrate, GaN substrate, GaAs substrate, GaP substrate, glass substrate, other applicable substrates, or a combination thereof, but the present disclosure is not limited thereto. For example, the epitaxial process may include a molecular-beam epitaxy (MBE) process, a metalorganic chemical vapor deposition (MOCVD) process, a hydride vapor phase epitaxy (HVPE) process, another applicable epitaxial process, or a combination thereof, but the present disclosure is not limited thereto.

In some embodiments, the conductive type of the dopants doped in the semiconductor layer 102a and the conductive type of the dopants doped in the semiconductor layer 102b may be opposite to each other (e.g., the semiconductor layer 102a may be doped with n-type dopants, and the semiconductor layer 102b may be doped with p-type dopants). For example, the semiconductor layer 102a and the semiconductor layer 102b may be in-situ doped or doped by an ion implantation process, but the present disclosure is not limited thereto. For example, in some embodiments, the semiconductor layer 102a may be made of n-type GaN doped with dopants such as silicon or oxygen, and the semiconductor layer 102b may be made of p-type GaN doped with dopants such as magnesium, but the present disclosure is not limited thereto.

In some embodiments, the semiconductor layer 102a, the semiconductor layer 102b, and the light-emitting portion 102e may be patterned by an applicable patterning process. For example, the patterning process may include a lithography process, an etching process, other applicable processes, or a combination thereof. In some embodiments, the lithography process may include resist coating, soft baking, exposure, post-exposure baking, developing, other applicable processes, or a combination thereof, but the present disclosure is not limited thereto. In some embodiments, the etching process may include a wet etching process, a dry etching process, other applicable processes, or a combination thereof, but the present disclosure is not limited thereto.

In some embodiments, the conductive pad 102c and the conductive pad 102d may be respectively made of a metal, other applicable conductive materials, or a combination thereof, but the present disclosure is not limited thereto. For example, the metal may include Cu, W, Ag, Sn, Ni, Cr, Ti, Pb, Au, Bi, Sb, Zn, Zr, Mg, In, Te, Ga, other applicable metals, alloys thereof, or a combination thereof. In some embodiments, the conductive pad 102c and the conductive pad 102d may be respectively made of a transparent conductive material. For example, the transparent conductive material may include ITO, SnO, IZO, IGZO, ITZO, ATO, AZO, other applicable transparent conductive materials, or a combination thereof, but the present disclosure is not limited thereto.

In some embodiments, a blanket layer (not shown in the figures) of a metal or a transparent conductive material may be formed on the semiconductor layer 102a and the semiconductor layer 102b by a physical vapor deposition process (e.g., evaporation process or sputtering process), an electro-plating process, an atomic layer deposition process, other applicable processes, or a combination thereof, and then a patterning process such as a lithography process and an etching process may be used to pattern the blanket layer of the metal or transparent conductive material to form the conductive pad 102c and the conductive pad 102d. In some embodiments, the conductive pad 102c and the conductive pad 102d may be the electrodes of the light-emitting diode 102, and may be used to provide an electrical connection with the substrate 100 of the display device 10. For example, one of the conductive pad 102c and the conductive pad 102d may be the p-type electrode of the light-emitting diode 102, and the other of the conductive pad 102c and the conductive pad 102d may be the n-type electrode of the light-emitting diode 102. In some embodiments, the conductive pad 102c is in direct contact with the semiconductor layer 102b, and the conductive pad 102d is in direct contact with the semiconductor layer 102a.

It should be understood that the elements and/or the forming methods of the light-emitting diode 104 and the light-emitting diode 106 may be the same as or similar to those of the light-emitting diode 102. Furthermore, the light-emitting diode 104 and the light-emitting diode 106 may respectively include a semiconductor layer 104a and a semiconductor layer 106a the same as or similar to the semiconductor layer 102a, the light-emitting diode 104 and the light-emitting diode 106 may both include another semiconductor layer (not shown in the figures) the same as or similar to the semiconductor layer 102b, the light-emitting diode 104 and the light-emitting diode 106 may respectively include a light-emitting portion 104e and a light-emitting portion 106e the same as or similar to the light-emitting portion 102e, the light-emitting diode 104 and the light-emitting diode 106 may respectively include a conductive pad 104c and a conductive pad 106c the same as or similar to the conductive pad 102c, and the light-emitting diode 104 and the light-emitting diode 106 may respectively include a conductive pad 104d and a conductive pad 106d the same as or similar to the conductive pad 102d. In some embodiments, the dimensions, the shapes, and/or the sizes of these light-emitting diodes may be substantially the same as each other according to the design requirements, but the present disclosure is not limited thereto. In some other embodiments, the dimensions, the shapes, and/or the sizes of these light-emitting diodes may be different from each other according to the design requirements.

In some embodiments, as shown in FIG. 1A, in a pixel (e.g., pixels P1, P2, P3, P4, P5, P6, P7, and P8) of the display device 10, the distance (e.g., minimum distance) between conductive pads corresponding to the light-emitting portions of two adjacent light-emitting diodes is less than the distance (e.g., minimum distance) between the conductive pads not corresponding to the light-emitting portions of the two adjacent light-emitting diodes. For example, in some embodiments, as shown in FIG. 1A, in a pixel of the display device 10, the distance D1 between the conductive pad 102c corresponding to the light-emitting portion 102e of the light-emitting diode 102 and the conductive pad 104c corresponding to the light-emitting portion 104e of the light-emitting diode 104 is less than the distance D2 between the conductive pad 102d not corresponding to the light-emitting portion 102e of the light-emitting diode 102 and the conductive pad 104d not corresponding to the light-emitting portion 104e of the light-emitting diode 104. For example, in some embodiments, as shown in FIG. 1A, in a pixel of the display device 10, the distance D3 between the conductive pad 104c corresponding to the light-emitting portion 104e of the light-emitting diode 104 and the conductive pad 106c corresponding to the light-emitting portion 106e of the light-emitting diode 106 is less than the distance D4 between the conductive pad 104d not corresponding to the light-emitting portion 104e of the light-emitting diode 104 and the conductive pad 106d not corresponding to the light-emitting portion 106e of the light-emitting diode 106.

In some embodiments, as shown in FIG. 1A, since the distance D1 is less than the distance D2, and/or the distance D3 is less than the distance D4, there is no case where the light-emitting portions of the light-emitting diodes are adjacent between two adjacent pixels of the display device 10. Therefore, the mutual light interference between two adjacent pixels may be reduced, and the contrast ratio of the display device 10 may be increased. For example, as shown in FIGS. 1A and 1B, the light-emitting diode 104 of the pixel P1 of the display device 10 may be adjacent to the light-emitting diode 102 of the pixel P2 of the display device 10, and the conductive pad 102d of the light-emitting diode 102 of the pixel P2 is disposed between the light-emitting portion 104e of the light-emitting diode 104 of the pixel P1 and the light-emitting portion 102e of the light-emitting diode 102 of the pixel P2. Therefore, the light-emitting portion 104e of the light-emitting diode 104 of the pixel P1 is not adjacent to the light-emitting portion 102e of the light-emitting diode 102 of the pixel P2, and thus the mutual light interference between the pixel P1 and the pixel P2 may be reduced.

For example, in some embodiments, the ratio of the distance D1 to the distance D2 may be greater than zero and less than one (e.g., 0<(D1/D2)<1), and the ratio of the distance D3 to the distance D4 may be greater than zero and less than one (e.g., 0<(D3/D4)<1).

In some embodiments, the light-emitting diodes corresponding to a pixel of the display device 10 may be arranged in a triangle. For example, as shown in FIG. 1A, the connecting lines of the geometric centers of the conductive pad 102c of the light-emitting diode 102, the conductive pad 104c of the light-emitting diode 104, and the conductive pad 106c of the light-emitting diode 106 corresponding to a pixel of the display device 10 form a triangle, but the present disclosure is not limited thereto. In some other embodiments, a pixel of the display device 10 may correspond to or include more light-emitting diodes which are arranged in a polygon or free shape. The shapes discussed above are examples and not intended to limit the scope of the present disclosure.

In some embodiments, the light-emitting portions and the conductive pads corresponding to the light-emitting portions of the light-emitting diodes of a pixel of the display device 10 are disposed toward the interior of the pixel, and the conductive pads not corresponding to the light-emitting portions are disposed in the periphery of the pixel, and thus the contrast ratio of the display device 10 may be increased. For example, as shown in FIG. 1A, in some embodiments, in a pixel (e.g., pixels P1, P2, P3, P4, P5, P6, P7, and P8) of the display device 10, the light-emitting portion 102e and the conductive pad 102c of the light-emitting diode 102, the light-emitting portion 104e and the conductive pad 104c of the light-emitting diode 104, and the light-emitting portion 106e and the conductive pad 106c of the light-emitting diode 106 are disposed toward the interior of the pixel, and the conductive pad 102d of the light-emitting diode 102, the conductive pad 104d of the light-emitting diode 104, and the conductive pad 106d of the light-emitting diode 106 are disposed in the periphery of the pixel.

In some embodiments, two light-emitting diodes in a pixel (e.g., pixels P1, P2, P3, P4, P5, P6, P7, and P8) of the display device 10 may have an included angle therebetween. For example, the included angel may be defined as the angle between the central connecting line (which extends in one direction) of two adjacent conductive pads (e.g., conductive pad 102c and conductive pad 102d) of one light-emitting diode (e.g., the light-emitting diode 102) and the central connecting line (which extends in another direction) of two adjacent conductive pads (e.g., conductive pad 104c and conductive pad 104d) of another light-emitting diode (e.g., the light-emitting diode 104). In some embodiments, as shown in FIG. 1A, in a pixel (e.g., pixels P1, P2, P3, P4, P5, P6, P7, and P8) of the display device 10, the included angle Θ₁ between the light-emitting diode 102 and the light-emitting diode 104, and the included angle Θ₂ between the light-emitting diode 102 and the light-emitting diode 106 may be substantially equal to 90°, but the present disclosure is not limited thereto. In some other embodiments, the included angle Θ₁ between the light-emitting diode 102 and the light-emitting diode 104, and the included angle Θ₂ between the light-emitting diode 102 and the light-emitting diode 106 of a pixel (e.g., pixels P1, P2, P3, P4, P5, P6, P7, and P8) of the display device 10 may be any other applicable angles according to design requirements. For example, in some embodiments, as shown in FIG. 1A', the included angle Θ₁ between the light-emitting diode 102 and the light-emitting diode 104, and the included angle Θ₂ between the light-emitting diode 102 and the light-emitting diode 106 may each be an acute angle. In some other embodiments, the light-emitting diodes of the display device 10 may be arranged in such a way that they are mirror-symmetrical to the light-emitting diodes of the embodiments of FIG. 1A' (e.g., mirror-symmetrical with respect to the Y direction shown in FIG. 1A'). It should be understood that although the included angel Θ₁ is substantially equal to the included angle Θ₂ in the embodiments illustrated in FIG. 1A and FIG. 1A', the present disclosure is not limited thereto. In some other embodiments, the included angle Θ₁ between the light-emitting diode 102 and the light-emitting diode 104 may be designed to be asymmetrical to the included angle Θ₂ between the light-emitting diode 102 and the light-emitting diode 106, for example, the included angle Θ₁ may be greater than or less than the included angle Θ₂.

In some embodiments, the light-emitting diode 102, the light-emitting diode 104, and the light-emitting diode 106 may be the same color (i.e., the emitting light of the light-emitting diode 102, the emitting light of the light-emitting diode 104, and the emitting light of the light-emitting diode 106 are the same color), and therefore a wavelength conversion layer (not shown in the figures) may be disposed on the substrate 100 of the display device 10 so that the display device 10 can emit white light. For example, the light-emitting diode 102, the light-emitting diode 104, and the light-emitting diode 106 may be blue light-emitting diodes, but the present disclosure is not limited thereto. In some embodiments, "two light-emitting diodes being the same color" means the absolute value of the difference between the wavelength corresponding to the maximum peak of the output spectrum of one light-emitting diode (e.g., light-emitting diode 102) and the wavelength corresponding to the maximum peak of the output spectrum of another light-emitting diode (e.g., light-emitting diode 104) is smaller than or equal to 2 nm. On the other hand, in some embodiments, "two light-emitting diodes being different colors" means the absolute value of the difference between the wavelength corresponding to the maximum peak of the output spectrum of one light-emitting diode (e.g., light-emitting diode 102) and the wavelength corresponding to the maximum peak of the output spectrum of another light-emitting diode (e.g., light-emitting diode 104) is larger than 2nm.

In some embodiments, the light-emitting diode 102, the light-emitting diode 104, and the light-emitting diode 106 may be different colors (i.e., the emitting light of the light-emitting diode 102, the emitting light of the light-emitting diode 104, and the emitting light of the light-emitting diode 106 are different colors). For example, in some embodiments, the light-emitting diode 102 of the display device 10 is a blue light-emitting diode, the light-emitting diode 104 of the display device 10 is a red light-emitting diode, and the light-emitting diode 106 of the display device 10 is a green light-emitting diode, but the present disclosure is not limited thereto.

As shown in FIGS. 1B and 1C, the substrate 100 may include a bonding pad group 100A, a bonding pad group 100B, and a bonding pad group 100C used to bond the light-emitting diode 102, the light-emitting diode 104, and the light-emitting diode 106. In other words, the light-emitting diode 102, the light-emitting diode 104, and the light-emitting diode 106 may be bonded to and electrically connected to the substrate 100 through the bonding pad group 100A, the bonding pad group 100B, and the bonding pad group 100C.

In some embodiments, as shown in FIGS. 1A and 1C, the bonding pad groups of the substrate 100 are disposed corresponding to the light-emitting diodes. In some embodiments, a bonding pad group (e.g., the bonding pad group 100A, the bonding pad group 100B, and the bonding pad group 100C) may be disposed corresponding to a light-emitting diode (e.g., the light-emitting diode 102, the light-emitting diode 104, and the light-emitting diode 106). For example, in some embodiments, as shown in FIGS. 1A and 1C, the pixel P1 of the display device 10 may correspond to three light-emitting diodes (i.e., the light-emitting diode 102, the light-emitting diode 104, and the light-emitting diode 106), and therefore the substrate 100 may also include three bonding pad groups (i.e., the bonding pad group 100A, the bonding pad group 100B, and the bonding pad group 100C) corresponding to the pixel P1.

In some embodiments, a bonding pad group may include at least one bonding pad. For example, as shown in FIGS. 1B and 1C, in some embodiments, the boding pad group 100A may include two bonding pads 100a and 100a' which are adjacent to each other, the bonding pad group 100B may include two bonding pads 100b and 100b' which are adjacent to each other, and the bonding pad group 100C may include two bonding pads 100c and 100c' which are adjacent to each other.

In some embodiments, the bonding pad 100a may correspond to the conductive pad 102c corresponding to the light-emitting portion 102e of the light-emitting diode 102, the bonding pad 100a' may correspond to the conductive pad 102d not corresponding to the light-emitting portion 102e of the light-emitting diode 102, the bonding pad 100b may correspond to the conductive pad 104c corresponding to the light-emitting portion 104e of the light-emitting diode 104, the bonding pad 100b' may correspond to the conductive pad 104d not corresponding to the light-emitting portion 104e of the light-emitting diode 104, the bonding pad 100c may correspond to the conductive pad 106c corresponding to the light-emitting portion 106e of the light-emitting diode 106, the bonding pad 100c' may correspond to the conductive pad 106d not corresponding to the light-emitting portion 106e of the light-emitting diode 106. In other words, in these embodiments, the bonding pad 100a may be bonded to and electrically connected to the conductive pad 102c, the bonding pad 100a' may be bonded to and electrically connected to the conductive pad 102d, the bonding pad 100b may be bonded to and electrically connected to the conductive pad 104c, the bonding pad 100b' may be bonded to and electrically connected to the conductive pad 104d, the bonding pad 100c may be bonded to and electrically connected to the conductive pad 106c, the bonding pad 100c' may be bonded to and electrically connected to the conductive pad 106d. In some embodiments, from a top view of the substrate, the shapes of the bonding pads may be designed to be the same as or different from the shapes of their own corresponding conductive pads of the light-emitting diodes. For example, the shapes of the bonding pads may be round or polygon, but the present disclosure is not limited thereto. In some embodiments, the bonding pads may be designed to be any other applicable shape according to the design requirements.

In some embodiments, a flip chip bonding process may be used to bond the light-emitting diode 102, the light-emitting diode 104, and the light-emitting diode 106 onto the substrate 100 through the bonding pad group 100A, the bonding pad group 100B, and the bonding pad group pad 100C.

It should be understood that although the above paragraphs are discussed by using an example in which a pixel (e.g., pixels P1, P2, P3, P4, P5, P6, P7, and P8) of the display device 10 corresponds to or includes three bonding pad groups (i.e., the boding pad group 100A, the bonding pad group 100B, and the bonding pad group 100C), the present disclosure is not limited thereto. In some other embodiments, a pixel of the display device may correspond to or include any other applicable number of bonding pad groups according to the design requirements (e.g., according to the number of light-emitting diodes which a pixel corresponds to or includes).

In some embodiments, the bonding pad group 100A, the bonding pad group 100B, and the bonding pad group 100C may be made of a metal, other applicable conductive materials, or a combination thereof, but the present disclosure is not limited thereto. For example, the metal may include Cu, W, Ag, Sn, Ni, Cr, Ti, Pb, Au, Bi, Sb, Zn, Zr, Mg, In, Te, Ga, other applicable metals, alloys thereof, or a combination thereof.

For example, the substrate 100 may include a driving circuit (not shown in the figures), and the driving circuit may be electrically connected to the light-emitting diode 102, the light-emitting diode 104, and the light-emitting diode 106, so as to control and/or adjust the brightness of these light-emitting diodes. In some embodiments, the substrate 100 may be a thin-film transistor (TFT) array substrate, but the present disclosure is not limited thereto.

It should be understood that although they are not shown in the figures, the display device 10 may also include some other elements (e.g., a cover plate or an optical film). For example, the cover plate may be made of glass, indium tin oxide, polyimide, polyethylene terephthalate, other applicable materials, or a combination thereof, but the present disclosure is not limited thereto. For example, the optical film may include a diffuser film, a condenser lens, other applicable optical films, or a combination thereof, but the present disclosure is not limited thereto.

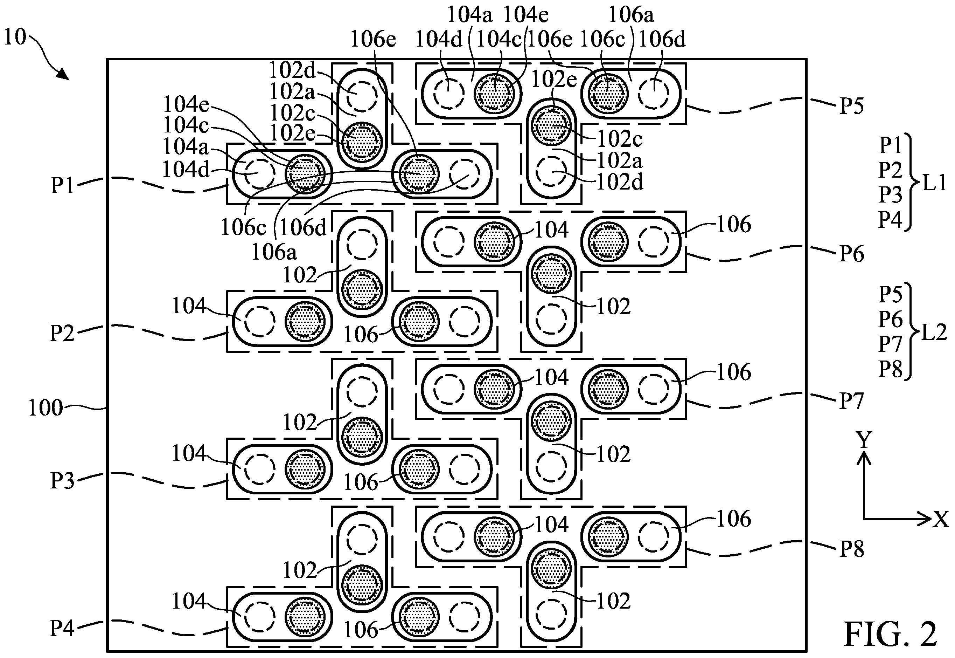

FIG. 2 illustrates some variations of the display device 10 of the present embodiment. It should be noted that, unless otherwise specified, the elements of the variation embodiments the same as or similar to those of the above embodiments will be denoted by the same reference numerals, and the forming methods thereof may be the same as or similar to those of the above embodiments.

In some embodiments, the pixels of the display device 10 may be staggered to each other, and thus the resolution of the display device 10 may be increased. For example, in some embodiments, as shown in FIG. 2, the display device 10 may include a first pixel column L1, and a second pixel column L2 adjacent to the first pixel column L1 in the direction X, the first pixel column L1 may include a plurality of pixels P1, P2, P3, and P4 which are aligned with each other in the direction Y, the second pixel column L2 may include a plurality of pixels P5, P6, P7, and P8 which are aligned with each other in the direction Y, and the pixels of the first pixel column L1 and the pixels of the second pixel column L2 may be staggered to each other. For example, as shown in FIG. 2, the light-emitting diode 106 of the pixel P1 of the first pixel column L1 may be disposed between the light-emitting diode 104 of the pixel P5 of the second pixel column L2 and the light-emitting diode 104 of the pixel P6 of the second pixel column L2.

In summary, in the display device of the present embodiment, the distance between conductive pads corresponding to the light-emitting portions of two adjacent light-emitting diodes is less than the distance between the conductive pads not corresponding to the light-emitting portions of the two adjacent light-emitting diodes, thereby increasing the contrast ratio of the display device. In addition, in some embodiments, the pixels of the display device may be staggered to each other, and thus the resolution of the display device may be increased.

Example 2, not forming part of the present invention.

One difference between Example 1 and Example 2 is that two adjacent pixels of the display device 30 of Example 2 may share or jointly correspond to at least one light-emitting diode, so that the display device 30 may have higher resolution.

It should be noted that, unless otherwise specified, the elements of Example 2 the same as or similar to those of the above embodiments will be denoted by the same reference numerals, and the forming methods thereof may be the same as or similar to those of the above embodiments.

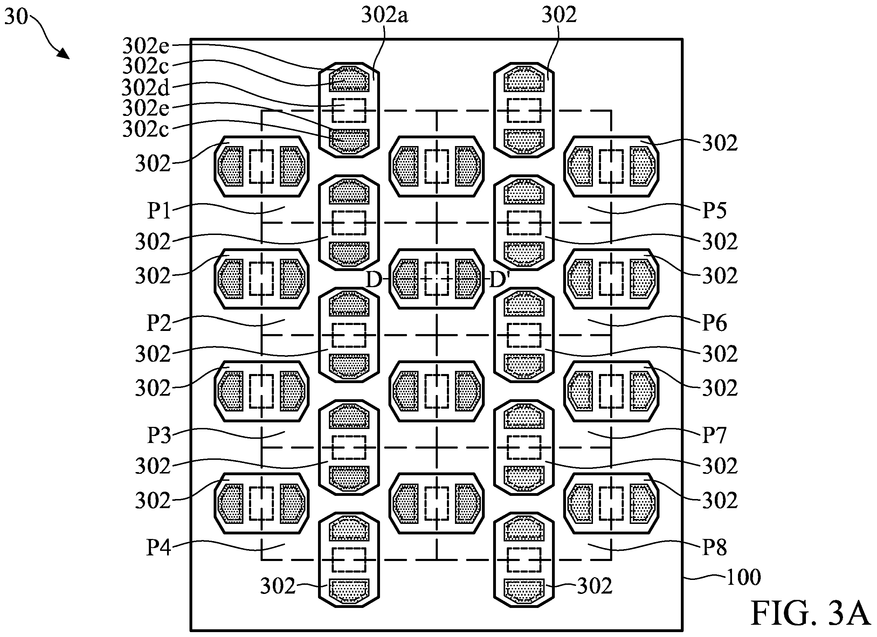

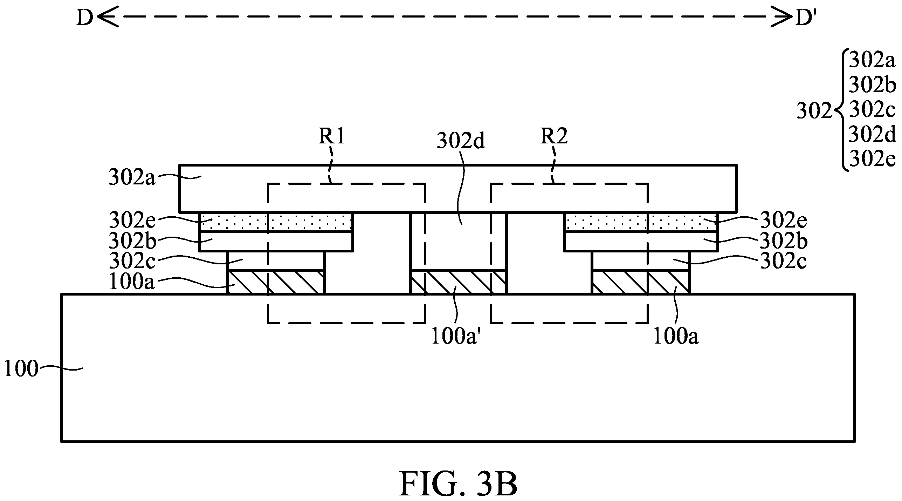

FIG. 3A illustrates a top view of the display device 30 of the present embodiment, and FIG. 3B illustrates a cross-sectional view of the display device 30 along the cut line D-D' of FIG. 3A.

As shown in FIG. 3A, the display device 30 may include a substrate 100, and a plurality of light-emitting diodes 302 disposed on the substrate 100. In some embodiments, the display device 30 may include a plurality of pixels (e.g., pixels P1, P2, P3, P4, P5, P6, P7, and P8).

In some embodiments, as shown in FIG. 3B, one light-emitting diode 302 may include two light-emitting portions 302e which are separated from each other, two semiconductor layers 302b which are separated from each other, and two conductive pads 302c which are separated from each other. In these embodiments, one light-emitting diode 302 may include two current paths R1 and R2, the current path R1 corresponds to one of the two light-emitting portions 302e (e.g., the light-emitting portion 302e on the left side of FIG. 3B), the current path R2 corresponds to the other of the two light-emitting portions 302e (e.g., the light-emitting portion 302e on the right side of FIG. 3B), and the current path R1 and the current path R2 share the conductive pad 302d. In some embodiments, the two separated light-emitting portions 302e of the light-emitting diode 302 may correspond to different pixels (or sub-pixels). Furthermore, the emitting lights of the two separated light-emitting portions 302e of the light-emitting diode 302 may correspond to different pixels (or sub-pixels). For example, the light-emitting portion 302e of the light-emitting diode 302 illustrated on the left side of FIG. 3B and the emitting light thereof may correspond to the pixel P2, and the light-emitting portion 302e of the light-emitting diode 302 illustrated on the right side of FIG. 3B and the emitting light thereof may correspond to the pixel P6 adjacent to the pixel P2. In other words, the pixel P2 and the pixel P6 of the display device 30 may share or jointly correspond to the light-emitting diode 302 illustrated in FIG. 3B.

It should be understood that although the above paragraphs are discussed by using an example in which the light-emitting diode 302 has two separated light-emitting portions 302e, the present disclosure is not limited thereto. For example, in some other embodiments, the light-emitting diode 302 may have more separated light-emitting portions 302e (e.g., more than two light-emitting portions 302e) according to design requirements, and the number of semiconductor layers 302b and the number of conductive pads 302c may be increased accordingly.

In some embodiments, since the light-emitting diode 302 has a plurality of separated light-emitting portions 302e, two adjacent pixels of the display device 30 may share or jointly correspond to at least one light-emitting diode 302, increasing the resolution of the display device 30. In addition, in some embodiments, the plurality of separated light-emitting portions 302e of the light-emitting diode 302 may share one conductive pad 302d, and thus the resolution of the display device 30 may be further increased.

Example 3, not forming part of the present invention.

One difference between Example 1 and Example 3 is that the light-emitting diode of the display device 40 of Example 3 has a plurality of separated light-emitting portions, and thus the manufacturing cost of the display device 40 may be lower.

It should be noted that, unless otherwise specified, the elements of Example 3 the same as or similar to those of the above embodiments will be denoted by the same reference numerals, and the forming methods thereof may be the same as or similar to those of the above embodiments.

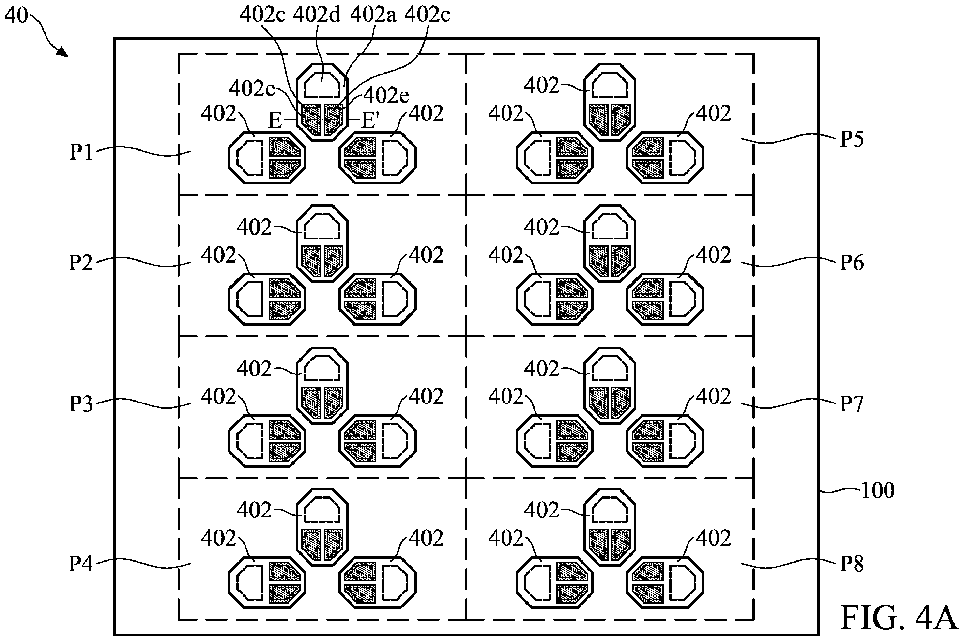

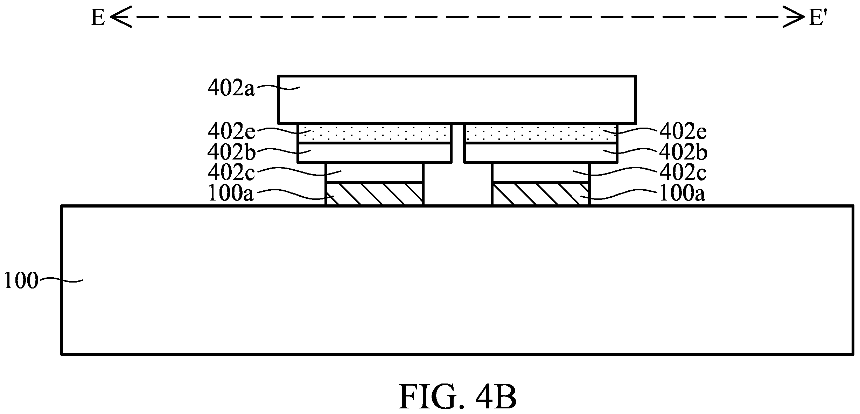

FIG. 4A illustrates a top view of the display device 40 of the present example, and FIG. 4B illustrates a cross-sectional view of the display device 40 along the cut line E-E' of FIG. 4A.

As shown in FIG. 4A, the display device 40 may include a substrate 100, and a plurality of light-emitting diodes 402 disposed on the substrate 100. In some embodiments, the display device 40 may include a plurality of pixels (e.g., pixels P1, P2, P3, P4, P5, P6, P7, and P8).

In some embodiments, the light-emitting diodes 402 which a pixel of the display device 40 corresponds to may be the same color, but the present disclosure is not limited thereto. In some other embodiments, the light-emitting diodes 402 which a pixel of the display device 40 corresponds to may be different colors.

In some embodiments, as shown in FIGS. 4A and 4B, one light-emitting diode 402 may include two light-emitting portions 402e separated from each other, two semiconductor layers 402b separated from each other, and two conductive pads 402c separated from each other. In some embodiments, as shown in the top view of FIG. 4A, the two separated light-emitting portions 402e of the light-emitting diode 402 may be disposed at the same side of the conductive pad 402d. In some embodiments, the two separated light-emitting portions 402e of the light-emitting diode 402 may share one conductive pad 402d.

It should be understood that although the above paragraphs are discussed by using an example in which the light-emitting diode 402 has two separated light-emitting portions 402e, the present disclosure is not limited thereto. For example, in some other embodiments, the light-emitting diode 402 may have more separated light-emitting portions 402e (e.g., more than two light-emitting portions 402e) according to design requirements, and the number of semiconductor layers 402b and the number of conductive pads 402c may be increased accordingly.

In some embodiments, since the light-emitting diode 402 has a plurality of separated light-emitting portions 402e, if one of the light-emitting portions 402e cannot emit the light normally (e.g., due to abnormal quality), the emitting light of any other light-emitting portion 402e may still be used to maintain the display function of the display device 40, and thus the yield of the display device 40 may be improved and the manufacturing cost may be reduced.

### Embodiment 1 of the present invention

One difference between Embodiment 1 and Example 1 is that the substrate 500 of the display device 50 of Embodiment 1 includes redundant bonding pad groups, so that the manufacturing process of the display device 50 may have a greater flexibility.

It should be noted that, unless otherwise specified, the elements of Embodiment 1 * the same as or similar to those of the above embodiments will be denoted by the same reference numerals, and the forming methods thereof may be the same as or similar to those of the above embodiments.

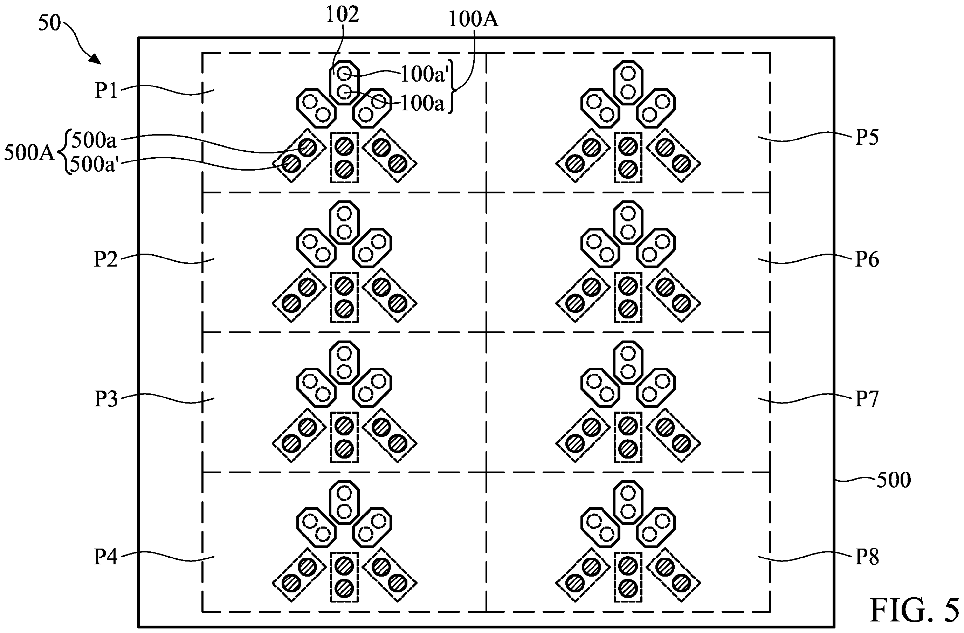

FIG. 5 illustrates a top view of the display device 50 of the present embodiment. As shown in FIG. 5, the display device 50 may include a substrate 500 (e.g., TFT array substrate) and a plurality of light-emitting diodes 102 disposed on the substrate 500. In some embodiments, the display device 50 may include a plurality of pixels (e.g., pixels P1, P2, P3, P4, P5, P6, P7, and P8).

In some embodiments, the light-emitting diodes 102 which a pixel of the display device 50 corresponds to may be the same color, but the present disclosure is not limited thereto. In some other embodiments, the light-emitting diodes 102 which a pixel of the display device 50 corresponds to may be different colors.

Similar to the display device 10 of Example 1, the substrate 500 of the display device 50 includes a plurality of bonding pad groups 100A, and the light-emitting diodes 102 are bonded to and electrically connected to the substrate 500 through the bonding pad groups 100A. As shown in FIG. 5, the substrate 500 of the display device 50 includes a plurality of redundant bonding pad groups 500A, and each of the redundant bonding pad groups 500A may include at least a pair of bonding pads (e.g., bonding pad 500a and bonding pad 500a').

In accordance with the present invention, the light-emitting diodes 102 are bonded to the substrate 500 through the bonding pad groups 100A, and then a quality test may be performed to test the qualities of these light-emitting diodes 102, if the qualities of these light-emitting diodes are abnormal (e.g., being unable to emit the light normally), other light-emitting diodes 102 may be bonded to the substrate 500 through the redundant bonding pad groups 500A, such that the display device 50 may still have normal display function. In other words, in these embodiments, since the substrate 500 includes the redundant bonding pad groups 500A, the manufacturing process of the display device 50 may have a greater flexibility and lower cost. Furthermore, similar to the display device 10 of Example 1, in some embodiments, the light-emitting portions 102e and the conductive pads 102c corresponding to the light-emitting portions 102e of the light-emitting diodes 102 which a pixel of the display device 50 corresponds to may be disposed toward the interior of the pixel, and the conductive pads 102d not corresponding to the light-emitting portions 102e of the pixel may be disposed in the periphery of the pixel. Therefore, in these embodiments, in a pixel of the display device 50, the light-emitting locations of the light-emitting diodes 102 bonded to the substrate 500 through the bonding pad groups 100A may be close to the light-emitting locations of the light-emitting diodes 102 bonded to the substrate 500 through the redundant bonding pad groups 500A. Thus, when the emitting lights of the light-emitting diodes 102 bonded to the substrate 500 through the bonding pad groups 100A are replaced with the emitting lights of the light-emitting diodes 102 bonded to the substrate 500 through the redundant bonding pad groups 500A, the visual effect may still be maintained as expected.

In some embodiments, after the quality test discussed above, the qualities of the light-emitting diodes 102 bonded to the substrate 500 through the bonding pad groups 100A are normal (e.g., able to emit the lights normally), so it may not be necessary to bond other light-emitting diodes 102 onto the substrate 500 through the redundant bonding pad groups 500A. Therefore, in these embodiments, the redundant bonding pad groups 500A of the final display device 50 may not be bonded with any light-emitting diodes 102.

In some embodiments, as shown in FIG. 5, in a pixel of the display device 50, the connecting lines of the geometric centers of the interior bonding pads (e.g., bonding pads 100a) of the bonding pad groups 100A and the interior bonding pads (e.g., bonding pads 500a) of the redundant bonding pad groups 500A, or the connecting lines of the geometric centers of the peripheral bonding pads (e.g., bonding pads 100a') of the bonding pad groups 100A and the peripheral bonding pads (e.g., bonding pads 500a') of the redundant bonding pad groups 500A may form a polygon, but the present disclosure is not limited thereto. In some embodiments, the bonding pad groups 100A and the redundant bonding pad groups 500A may be arranged in any other applicable shape according to the design requirements.

In some embodiments, in a pixel of the display device 50, the number of bonding pad groups 100A may be the same as the number of redundant bonding pad groups 500A. For example, as shown in FIG. 5, a pixel of the display device 50 corresponds to three bonding pad groups 100A and three redundant bonding pad groups 500A. In some other embodiments, in a pixel of the display device 50, the number of bonding pad groups 100A may be different from the number of redundant bonding pad groups 500A.

It should be understood that although the above paragraphs are discussed by using an example in which a pixel (e.g., pixels P1, P2, P3, P4, P5, P6, P7, and P8) of the display device 50 corresponds to or includes three bonding pad groups 100A and three redundant bonding pad groups 500A, the present disclosure is not limited thereto. In some other embodiments, a pixel of the display device 50 may correspond to or include any other applicable number of the bonding pad groups 100A and the redundant bonding pad groups 500A according to design requirements. It should be understood that the materials, functions of the bonding pads 500a and 500a' of the redundant bonding pad group 500A, and/or their corresponding relationships with the light-emitting diode 102 may be the same as or similar to those of the bonding pads 100a and 100a' of the bonding pad group 100A. For simplicity and clarity, the details will not be repeated.

### Embodiment 2 of the present invention

The light-emitting diodes of Embodiment 2 have high strength, so it may reduce the occurrence of cracks in the manufacturing process (e.g., a laser lift-off process) and reduce the manufacturing cost. Details of Embodiment 2 will be discussed in the following paragraphs.

It should be noted that, unless otherwise specified, the elements of Embodiment 2 the same as those of Embodiment 1 will be denoted by the same reference numerals, and the forming methods thereof may be the same as or similar to those of Embodiment 1.

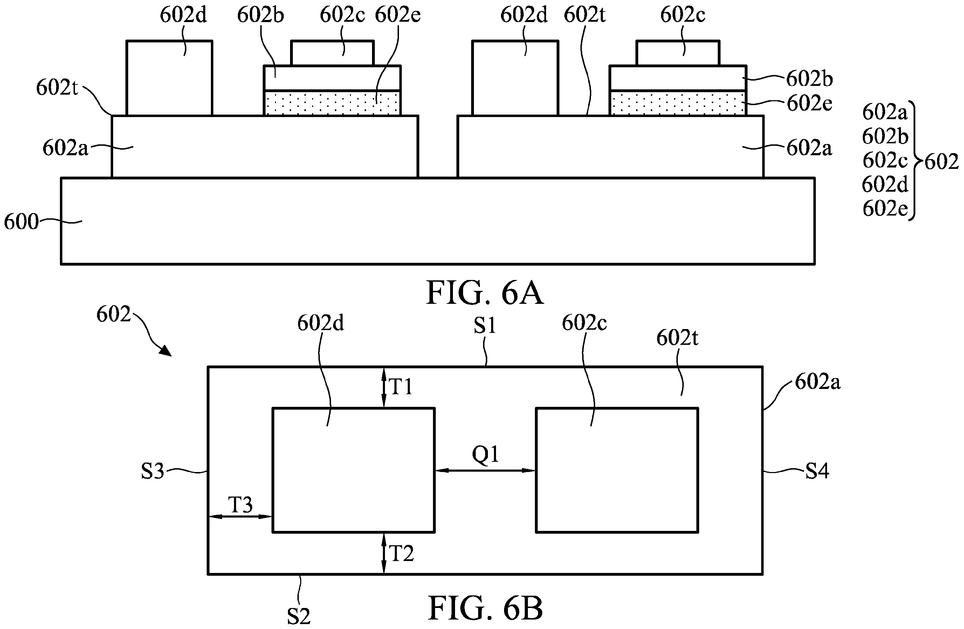

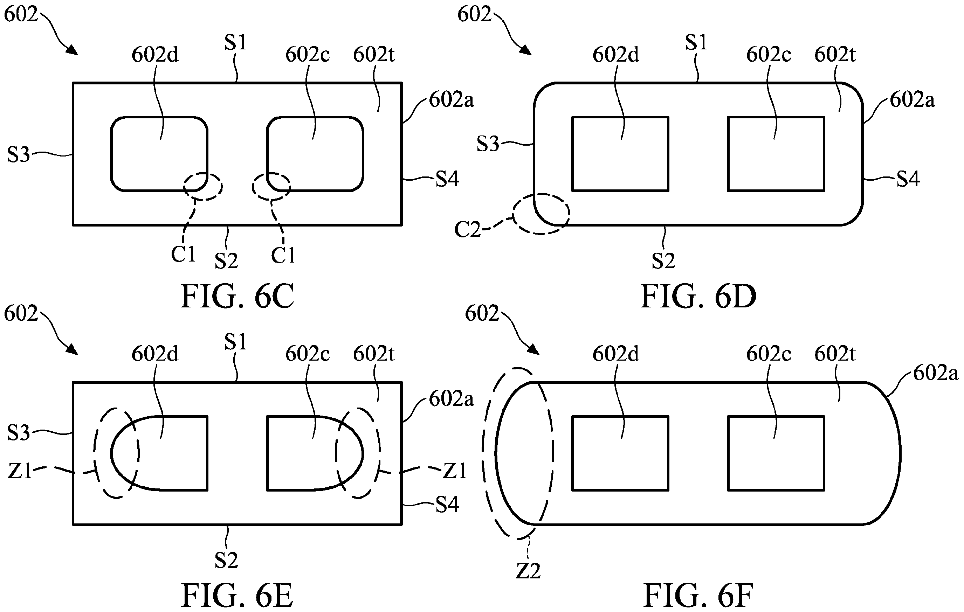

First, as shown in FIG. 6A, at least one light-emitting diode 602 is disposed on a substrate 600. For example, the substrate 600 may include an epitaxial substrate, but the present disclosure is not limited thereto. In some embodiments, the substrate 600 may include sapphire substrate, SiC substrate, Si substrate, MgAl₂O₄ substrate, MgO substrate, LiAlO₂ substrate, LiGaO₂ substrate, GaN substrate, GaAs substrate, GaP substrate, glass substrate, other applicable substrates, or a combination thereof, but the present disclosure is not limited thereto.

As shown in FIG. 6A, the light-emitting diode 602 may include a semiconductor layer 602a and a semiconductor layer 602b vertically stacked on each other, a light-emitting portion 602e disposed between the semiconductor layer 602a and the semiconductor layer 602b, a conductive pad 602c disposed on the semiconductor layer 602b, and a conductive pad 602d disposed on the semiconductor layer 602a. In some embodiments, the semiconductor layer 602b, the light-emitting portion 602e, the conductive pad 602c, and the conductive pad 602d may be disposed on a surface 602t of the semiconductor layer 602a. In some embodiments, as shown in FIG. 6A, the conductive pad 602c and the conductive pad 602d of the light-emitting diode 602 may be adjacent to each other, the conductive pad 602c may be located on the light-emitting portion 602e, and the conductive pad 602d may not be located on the light-emitting portion 602e. In some embodiments, the location of the semiconductor layer 602b and the location of the conductive pad 602c may correspond to the location of the light-emitting portion 602e. In other words, in these embodiments, in a top view, the semiconductor layer 602b and the conductive pad 602c at least partially overlap the light-emitting portion 602e.

For example, the semiconductor layer 602a may be the same as or similar to the semiconductor layer 102a, the semiconductor layers 602b may be the same as or similar to the semiconductor layer 102b, the light-emitting portions 602e may be the same as or similar to the light-emitting portion 102e, the conductive pads 602c may be the same as or similar to the conductive pad 102c, and the conductive pad 602d may be the same as or similar to the conductive pad 102d. In other words, the materials, functions, and/or forming methods of the elements of the light-emitting diode 602 may be the same as or similar to those of the light-emitting diode 102 of the above embodiments. For simplicity and clarity, the details will not be repeated.

Furthermore, in some embodiments, the conductive pad 602c and the conductive pad 602d may be made of a metal (e.g., Cu, W, Ag, Sn, Ni, Cr, Ti, Pb, Au, Bi, Sb, Zn, Zr, Mg, In, Te, Ga, other applicable metals, alloys thereof, or a combination thereof).

FIG. 6B illustrates a top view of the light-emitting diode 602 of the present embodiment. It should be understood that, for simplicity and clarity, only the semiconductor layer 602a, the conductive pad 602c, and the conductive pad 602d of the light-emitting diode 602 are illustrated in FIG. 6B.

As shown in FIG. 6B, the semiconductor layer 602a of the light-emitting diode 602 may have a plurality of sides (e.g., sides S1, S2, S3, and S4). In some embodiments, as shown in FIG. 6B, the semiconductor layer 602a of the light-emitting diode 602 may be substantially rectangular, but the present disclosure is not limited thereto. For example, the semiconductor layer 602a of the light-emitting diode 602 may be round, oval, oblong, hexagon, irregular shape, other applicable shapes, or a combination thereof.

In some embodiments, the distance (minimum distance) between at least one of the conductive pads 602c and 602d, and at least one of the sides (e.g., sides S1, S2, S3, and S4) of the semiconductor layer 602a may be less than or equal to 25 µm (e.g., in a range between 0.5µm and 25µm), and thus the edge strength of the light-emitting diode 602 may be increased, reducing the occurrence of cracks in the manufacturing process. For example, as shown in FIG. 6B, the distance (minimum distance) T1 between the conductive pad 602d and the side S1 of the semiconductor layer 602a may be less than or equal to 25µm (e.g., 0.5µm≦T1≦25µm).

Furthermore, in some embodiments, the distances (minimum distances) between at least one of the conductive pads 602c and 602d of the light-emitting diode 602, and all the adjacent sides of the semiconductor layer 602a may be less than or equal to 25 µm (e.g., in a range between 0.5µm and 25µm), and thus the edge strength of the light-emitting diode 602 may be further increased, further reducing the occurrence of cracks in the manufacturing process and reducing the manufacturing cost. For example, in some embodiments, as shown in FIG. 6B, the conductive pad 602d is adjacent to the sides S1, S2, and S3 of the semiconductor layer 602a, and each of the distance T1 between the conductive pad 602d and the side S1, the distance T2 between the conductive pad 602d and the side S2, and the distance T3 between the conductive pad 602d and the side S3 is less than or equal to 25µm (e.g., 0.5 µm≦T1≦25µm, 0.5 µm≦ T2≦25µm, 0.5µm≦T3≦25µm).

In some embodiments, the conductive pad 602c and the conductive pad 602d are made of the metals discussed above, these metals have high strength, and thus the edge strength of the light-emitting diode 602 may be further increased.

In some embodiments, the distance (e.g., minimum distance) between two adjacent conductive pads of the light-emitting diode 602 may be less than or equal to 30 µm (e.g., in a range between 2µm and 30µm), and thus the strength for supporting the light-emitting diode 602 may be increased. For example, as shown in FIG. 6B, in some embodiments, the conductive pads 602c and 602d of the light-emitting diode 602 may be adjacent to each other, and the distance Q1 (e.g., minimum distance) between the conductive pad 602c and the conductive pad 602d may be less than or equal to 30µm (e.g., 2µm≦Q1≦30µm). In some embodiments, the ratio of the distance between any one of the conductive pads (conductive pad 602c or conductive pad 602d) and any one of the sides (e.g., side S1, S2, S3, or S4) of the semiconductor layer 602a to the distance Q1 of two adjacent conductive pads may be greater than or equal to 0.05, and less than or equal to 0.9. When the above ratio range is satisfied, the edge strength of the light-emitting diode 602 and the supporting strength for the light-emitting diode 602 may both be increased.

In some embodiments, in a top view, the ratio of the sum of the areas of all conductive pads (e.g., the conductive pad 602c and the conductive pad 602d) of the light-emitting diode 602 to the area of the semiconductor layer 602a of the light-emitting diode 602 may be greater than or equal to 50% (e.g., greater than or equal to 50%, and less than or equal to 90%), and thus the strength of the light-emitting diode 602 may be increased.

It should be understood that although the above paragraphs are discussed by using an example in which two conductive pads (i.e., conductive pad 602c and conductive pad 602d) are disposed on the surface 602t of the semiconductor layer 602a of the light-emitting diode 602, the present disclosure is not limited thereto. For example, any applicable number of conductive pads (e.g., one, or more than two) may be disposed on the surface 602t of the semiconductor layer 602a of the light-emitting diode 602 according to the design requirements. For example, in some embodiments, the light-emitting diode 602 may be a vertical-type light-emitting diode, and thus there may be only one conductive pad disposed on the surface 602t of the semiconductor layer 602a, and there may be another conductive pad disposed on another surface of the semiconductor layer 602a opposite to the surface 602t.

FIGS. 6C to 6F illustrate some variations of the light-emitting diode 602 of the present embodiment. It should be noted that, unless otherwise specified, the elements of the variation embodiments the same as or similar to those of the above embodiments will be denoted by the same reference numerals, and the forming methods thereof may be the same as or similar to those of the above embodiments.

In some embodiments, the conductive pad of the light-emitting diode 602 may have at least one round corner, which may further reduce the occurrence of cracks of the light-emitting diode 602 in the manufacturing process (e.g., a laser lift-off process). For example, in some embodiments, as shown in FIG. 6C, the conductive pad 602d or the conductive pad 602c of the light-emitting diode 602 may have at least one round corner C1.

In some embodiments, the semiconductor layer 602a of the light-emitting diode 602 may have at least one round corner, which may further reduce the occurrence of cracks of the light-emitting diode 602 in the manufacturing process (e.g., a laser lift-off process). For example, in some embodiments, as shown in FIG. 6D, the semiconductor layer 602a of the light-emitting diode 602 may have at least one round corner C2.

In some embodiments, a curvature of the round corner C1 of the conductive pad (602d or 602c) may be different from a curvature of the round corner C2 of the semiconductor layer 602a, which may more effectively reduce the occurrence of cracks of the light-emitting diode 602 in the manufacturing process.

In some embodiments, the conductive pad of the light-emitting diode 602 may have at least one curved portion (e.g., a curved side), which may further reduce the occurrence of cracks of the light-emitting diode 602 in the manufacturing process (e.g., a laser lift-off process). For example, in some embodiments, as shown in FIG. 6E, the conductive pad 602d or the conductive pad 602c of the light-emitting diode 602 may have a curved portion (e.g., a curved side) Z1. In some embodiments, at least one side of the semiconductor layer 602a of the light-emitting diode 602 may have at least one curved portion (e.g., a curved side) Z2, which may further reduce the occurrence of cracks of the light-emitting diode 602 in the manufacturing process (e.g., a laser lift-off process).

In some embodiments, a radius of curvature of the curved portion Z1 of the conductive pad (602d or 602c) may be different from a radius of curvature of the round corner Z2 of the semiconductor layer 602a, which may more effectively reduce the occurrence of cracks of the light-emitting diode 602 in the manufacturing process.

Example 4, not forming part of the present invention.

In Example 4, the light-emitting diodes of the display device are bonded onto the substrate through a conductive adhesive layer, the conductive adhesive layer includes conductive materials, the conductive materials may be made of a metal having low melting point or an alloy having low eutectic point, and thus the reliability of the display device may be increased and the manufacturing cost may be reduced. The details will be discussed below.

It should be noted that, unless otherwise specified, the elements of Example 4 the same as or similar to those of the above examples will be denoted by the same reference numerals, and the forming methods thereof may be the same as or similar to those of the above examples.

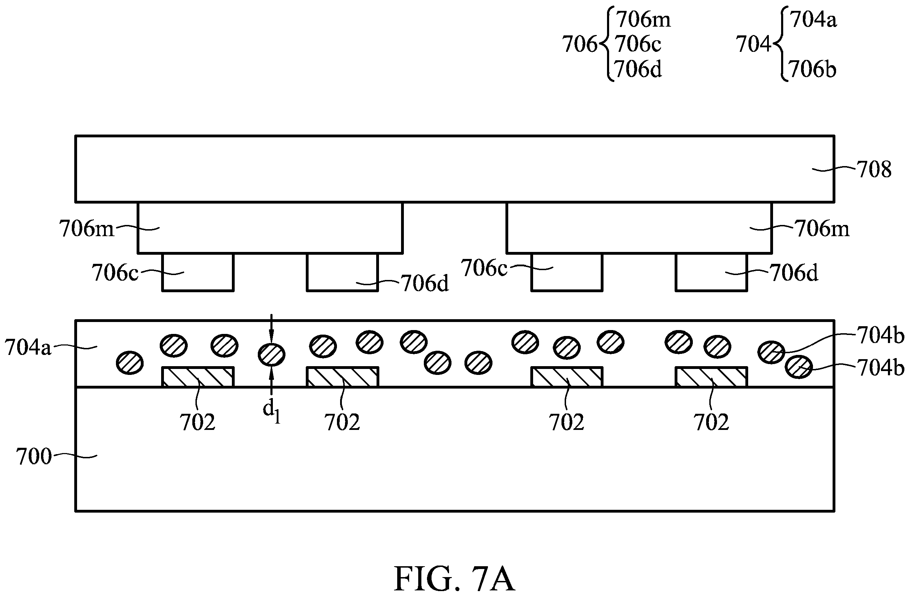

FIGS. 7A to 7D are a series of cross-sectional views illustrating a method for forming display devices of the present example.

First, as shown in FIG. 7A, a substrate 700 is provided. For example, the substrate 700 may include a TFT array substrate, a printed circuit board (PCB), a flexible printed circuit board, a polyimide substrate, a glass substrate, other applicable substrates, or a combination thereof, but the present disclosure is not limited thereto. In some embodiments, as shown in FIG. 7A, the substrate 700 may include at least one bonding pad 702. For example, the bonding pad 702 may be made of a metal, other applicable conductive materials, or a combination thereof. For example, the metal may include Cu, W, Ag, Sn, Ni, Cr, Ti, Pb, Au, Bi, Sb, Zn, Zr, Mg, In, Te, Ga, other applicable metals, alloys thereof, or a combination thereof, but the present disclosure is not limited thereto.

Still referring to FIG. 7A, in some embodiments, a conductive adhesive layer 704 is disposed on the substrate 700. For example, the conductive adhesive layer 704 may be an anisotropic conductive film or an anisotropic conductive paste (formed by a coating process on the substrate 700), but the present disclosure is not limited thereto. In some embodiments, the conductive adhesive layer 704 may include a non-conductive adhesive material 704a and a plurality of conductive materials 704b which are substantially randomly distributed in the non-conductive adhesive material 704a. For example, any one of the conductive materials 704b may be substantially round or oval in a cross-sectional view, but the present disclosure is not limited thereto. For example, the diameter d₁ of any one of the conductive materials 704b may be in a range between 0.1 µ m and 10µm, but the present disclosure is not limited thereto.

In some embodiments, the conductive materials 704b may be made of a metal having low melting point. For example, the metal having low melting point may include In, Ga, Sn, other applicable metals, or a combination thereof. In some embodiments, the metal having low melting point may include, for example, nano-metal powders (e.g., nano-silver powders, nano-copper powders, nano-gold powders, other applicable nano-metal powders, or a combination thereof), but the present disclosure is not limited thereto. In some embodiments, the conductive materials 704b may be made of a metal alloy having low eutectic point. For example, the metal alloy having low eutectic point may include In-Ag alloy, In-Sn alloy, Ag-Sn alloy, Sn-Zn alloy, Sn-Bi alloy, Sn-Au alloy, Sn-Ag-Cu alloy, In-Ag-Sn alloy, other applicable metal alloys, or a combination thereof.

In some embodiments of which the conductive materials 704b are made of a metal alloy having low eutectic point, the properties (e.g., the melting point, the hardness, and/or the toughness) of the conductive materials 704b may be adjusted by adjusting the composition ratios of the metals of the metal alloy, and thus the flexibility of the manufacturing process may be increased.

In some embodiments, the non-conductive adhesive material 704a may be a light curing material, a thermal curing material, other applicable materials, or a combination thereof. For example, the non-conductive adhesive material 704a may include gels (or glues) made of polymers (e.g., acrylic, epoxy, other applicable polymers, or a combination thereof), but the present disclosure is not limited thereto.

Still referring to FIG. 7A, at least one light-emitting diode 706 is provided on the substrate 700 and the conductive adhesive layer 704. As shown in FIG. 7A, in some embodiments, the light-emitting diode 706 may include a main portion 706m, a conductive pad 706c, and a conductive pad 706d. For example, the main portion 706m of the light-emitting diode 706 may include the elements the same as or similar to the semiconductor layer 102a, the semiconductor layer 102b, and the light-emitting portion 102e of the light-emitting diode 102 of the above embodiments, and the conductive pads 706c and 706d of the light-emitting diode 706 may be the same as or similar to the conductive pads 102c and 102d of the light-emitting diode 102 of the above embodiments. In some embodiments, a pick-up head 708 may be used to grasp the light-emitting diode 706 and move the light-emitting diode 706 to be on the substrate 700.

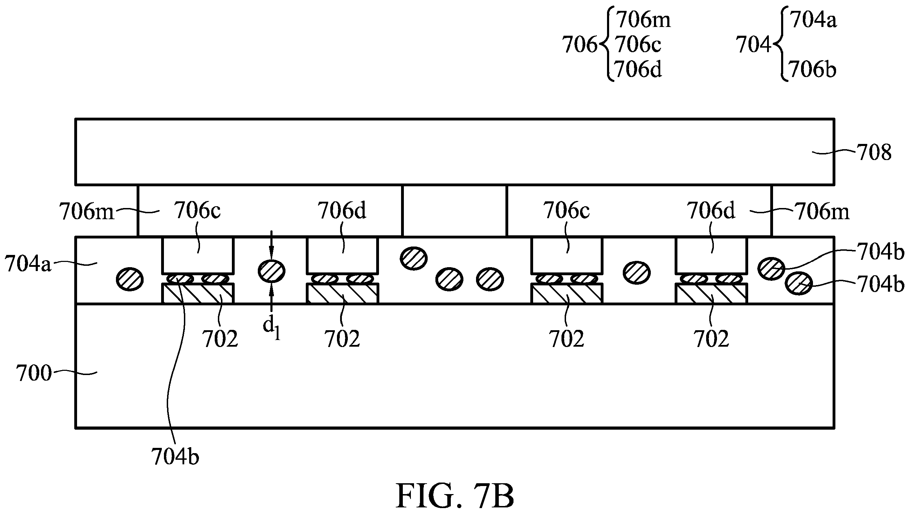

Then, as shown in FIG. 7B, in some embodiments, an attaching process is performed to attach the light-emitting diode 706 onto the conductive adhesive layer 704. In some embodiments, as shown in FIG. 7B, after the light-emitting diode 706 is attached onto the conductive adhesive layer 704, at least some of the conductive materials 704b are between the light-emitting diode 706 and the substrate 700. Furthermore, in some embodiments, after the light-emitting diode 706 is attached onto the conductive adhesive layer 704, at least some of the conductive materials 704b are between the conductive pad 706c (or the conductive pad 706d) of the light-emitting diode 706 and the bonding pad 702 of the substrate 700.

In some embodiments, the attaching process may include heating the non-conductive adhesive material 704a to an applicable temperature (e.g., in a range between 100 °C to 250 °C) to increase the flowability of the non-conductive adhesive material 704a. In some embodiments, the attaching process may include using the pick-up head 708 to apply an applicable pressure toward the substrate 700, such that the conductive materials 704b disposed between the conductive pad 706c (or 706d) and the bonding pad 702 may be slightly deformed. Then, in some embodiments, the pick-up head 708 is removed.

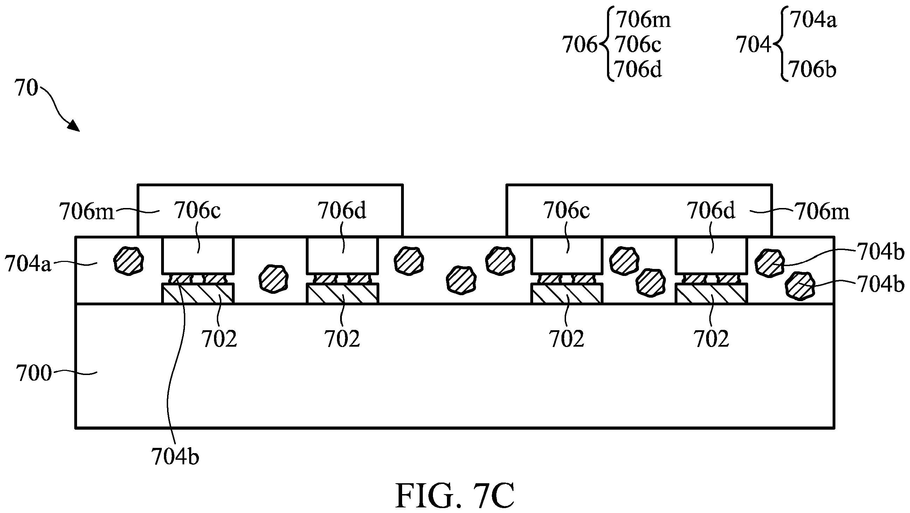

Then, as shown in FIG. 7C, in some embodiments, a bonding process may be performed to bond the bonding pad 702, the conductive materials 704b between the bonding pad 702 and the conductive pad 706c (or the conductive pad 706d), and the conductive pad 706c (or the conductive pad 706d), and a process for curing the non-conductive adhesive material 704a may be performed to form the display device 70 of the present embodiment. In some embodiments, the bonding process may include heating the conductive materials 704b between the bonding pad 702 and the conductive pad 706c (or the conductive pad 706d) to an applicable temperature (may also be referred to as the process temperature of the bonding process), so as to bond the conductive pad 706c (or the conductive pad 706d) of the light-emitting diode 706 and the bonding pad 702 of the substrate 700 through the conductive materials 704b. In some embodiments, since the conductive materials 704b are made of a metal having low melting point, or a metal alloy (e.g., In-Ag alloy, In-Sn alloy, Ag-Sn alloy, In-Ag-Sn alloy, or a combination thereof) having low eutectic point, the process temperature of the bonding process may be low (e.g., the process temperature of the bonding process may be in a range between 90°C and 180°C) and thus the manufacturing cost may be reduced.

In some embodiments, the non-conductive adhesive material 704a is a thermal curing material, and the curing temperature of the non-conductive adhesive material 704a is greater than the process temperature of the bonding process. Therefore, in these embodiments, after the light-emitting diode 706 is bonded to the substrate 700 by the bonding process, the non-conductive adhesive material 704a has not been cured yet, increasing the feasibility of rework. In other words, in these embodiments, after the bonding process, a quality test may be performed to test the qualities of the light-emitting diodes 706 bonded to the substrate 700, since the non-conductive adhesive material 704a has not been cured yet, the light-emitting diodes 706 which are tested to be abnormal in quality may still be removed from the substrate 700 and be replaced with other light-emitting diodes 706 before the curing process (e.g., heating the non-conductive adhesive material 704a to a temperature higher than or equal to the curing temperature of the non-conductive adhesive material 704a) is performed to cure the non-conductive adhesive material 704a.

In some embodiments, the non-conductive adhesive material 704a is a thermal curing material, and the curing temperature of the non-conductive adhesive material 704a is less than or equal to the process temperature of the bonding process. In other words, in these embodiments, the non-conductive adhesive material 704a is cured in the bonding process, reducing the occurrence of short circuit resulting from the connection between the conductive materials 704b in the bonding process.

In some embodiments, the non-conductive adhesive material 704a is a light curing material (e.g., UV light curing material). In these embodiments, the curing process for curing the non-conductive adhesive material 704a may not substantially affect the conductive materials 704b. In some embodiments of which the non-conductive adhesive material 704a is a light curing material, the curing process for curing the non-conductive adhesive material 704a may be performed after the bonding process, increasing the feasibility of rework. In some embodiments, when the non-conductive adhesive material 704a is a light curing material, the curing process for curing the non-conductive adhesive material 704a may be performed before the bonding process, reducing the occurrence of short circuit.

In some embodiments, as shown in FIG. 7C, after the bonding process, the contact areas of the conductive materials 704b and the bonding pad 702 are increased, and the contact areas of the conductive materials 704b and the conductive pad 706c (or the conductive pad 706d) are increased, and thus the peeling strength between the light-emitting diode 706 and the substrate 700 may be increased and the reliability of the display device 70 may also be increased. In some embodiments, since the contact areas of the conductive materials 704b and the bonding pad 702 are increased, and the contact areas of the conductive materials 704b and the conductive pad 706c (or the conductive pad 706d) are increased, the contact resistance may be reduced, and/or the thermal conductivity may be increased.

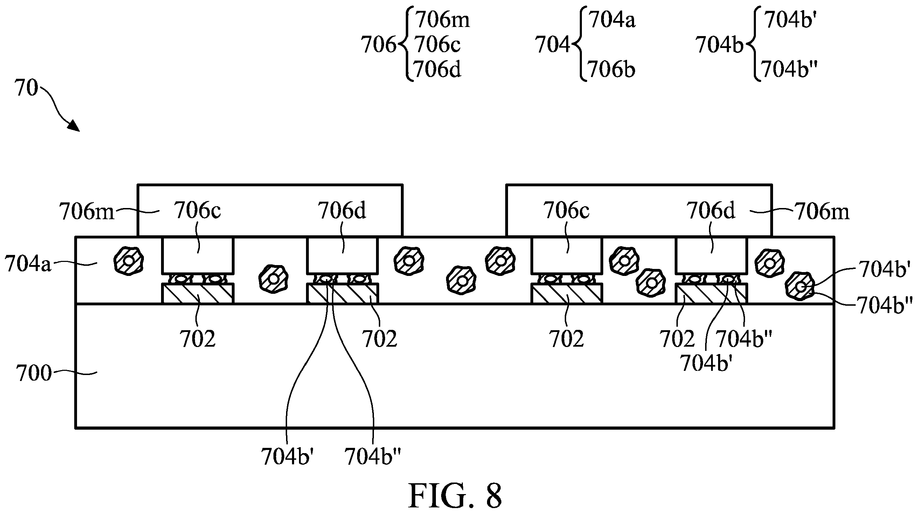

FIG. 8 illustrates some variations of the display device 70 of the present invention. It should be noted that, unless otherwise specified, the elements of the variation embodiments the same as those of the above embodiments will be denoted by the same reference numerals.

In the embodiments illustrated in FIG. 8, the conductive material 704b of the conductive adhesive layer 704 may include a core portion 704b' and a shell 704b" coated on the core portion 704b', the core portion 704b' may be made of a polymer, and the shell 704b" may be made of a metal or a metal alloy. For example, the core portion 704b' of the conductive adhesive layer 704 may be a sphere made of a polymer (may also be referred to as a polymer ball), and the metal or metal alloy shell 704b" may include a metal (e.g., In, Ga, Sn, or a combination thereof) having low melting point or a metal alloy (e.g., In-Ag alloy, In-Sn alloy, Ag-Sn alloy, Sn-Zn alloy, Sn-Bi alloy, Sn-Au alloy, Sn-Ag-Cu alloy, In-Ag-Sn alloy, or a combination thereof) having low eutectic point. In some embodiments, the conductive material 704b includes the polymer core portion 704b' and the metal or metal alloy shell 704b", and the electrical properties of the conductive material 704b of the variation embodiments illustrated in FIG. 8 may be the same as or similar to the electrical properties of the conductive material 704b of the above embodiments whose entirety is made of a metal or a metal alloy. In other words, the conductive material 704b including the polymer core portion 704b' and the metal or metal alloy shell 704b" may have a lower manufacturing cost and still maintain good conductive properties. In some embodiments, the core portions 704b' of all of the conductive materials 704b are covered by the metal or metal alloy shells 704b", but the present disclosure is not limited thereto. In some other embodiments, the core portions 704b' of only some of the conductive materials 704b are covered by the metal or metal alloy shells 704b". In summary, in the display device of the present embodiment, the conductive adhesive layer may include the conductive material made of a metal having low melting point or a metal alloy having low eutectic point, and thus the reliability of the display device may be increased.

Example 5, not forming part of the present invention.

One difference between Example 5 and Example 4 is that the conductive materials of the conductive adhesive layer of Example 5 are disposed corresponding to the bonding pads of the substrate and/or the conductive pads of the light-emitting diodes, and thus the occurrence of short-circuit may be reduced.

It should be noted that, unless otherwise specified, the elements of Example 5 the same as or similar to those of the above examples will be denoted by the same reference numerals, and the forming methods thereof may be the same as or similar to those of the above examples.

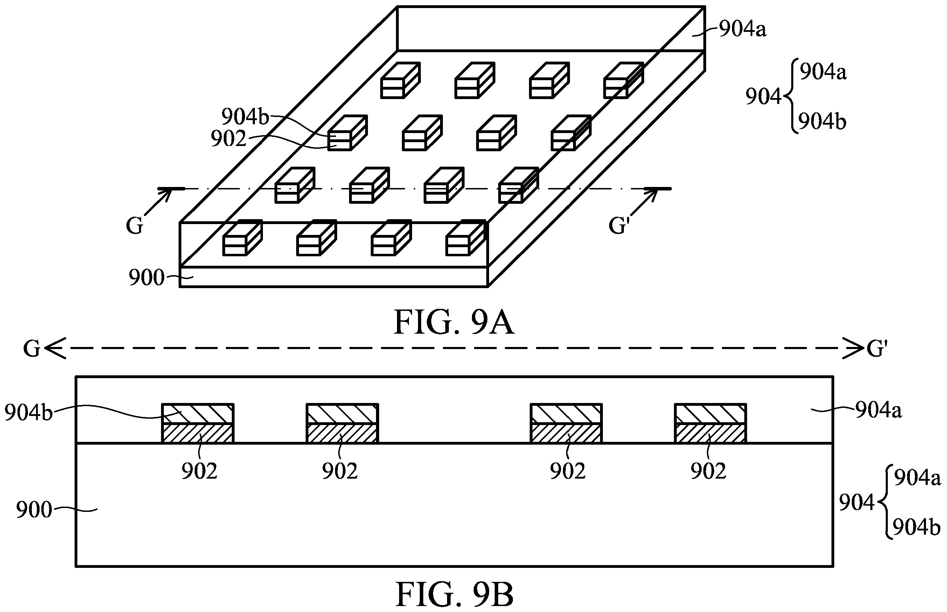

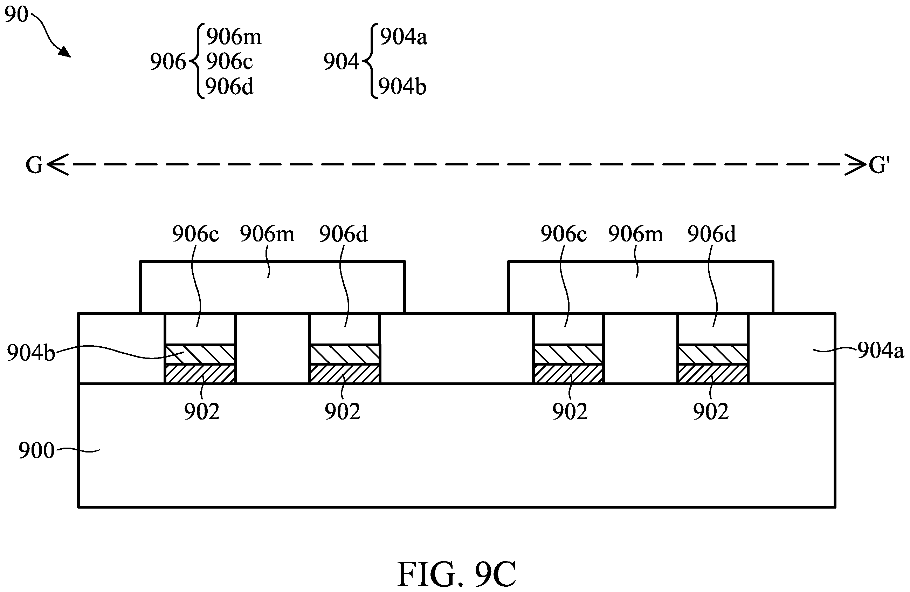

FIG. 9A illustrates a process perspective view, and FIG. 9B illustrates a cross-sectional view along the cut line G-G' of FIG. 9A. FIGS. 9B and 9C are a series of cross-sectional views illustrating a method for forming display devices according to the present example.

First, as shown in FIGS. 9A and 9B, a substrate 900 is provided. In some embodiments, the substrate 900 may include a plurality of boding pads 902 for bonding the light-emitting diodes. For example, the substrate 900 may be the same as or similar to the substrate 700 of the above embodiments, and the bonding pads 902 may be the same as or similar to the bonding pads 702 of the above embodiments. In some embodiments, as shown in FIG. 9A, the bonding pads 902 of the substrate 900 may be arranged in a two dimensional array, but the present disclosure is not limited thereto. In some embodiments, the bonding pads 902 of the substrate 900 may be arranged in a line, rhombus, hexagon, round, triangle, any other applicable shapes, or a combination thereof.

Still referring to FIGS. 9A and 9B, a conductive adhesive layer 904 is disposed on the substrate 900. In some embodiments, as shown in FIGS. 9A and 9B, the conductive adhesive layer 904 may include a plurality of conductive materials 904b disposed in a non-conductive adhesive material 904a. For example, the non-conductive adhesive material 904a may be the same as or similar to the non-conductive adhesive material 704a of the above embodiments, and the conductive materials 904b may be the same as or similar to the conductive materials 704b of the above embodiments. In other words, the non-conductive adhesive material 904a may be made of a light curing material, a thermal curing material, or a combination thereof, and the conductive materials 904b may be made of a metal having low melting point or a metal alloy having low eutectic point.

In some embodiments, as shown in FIGS 9A and 9B, the conductive materials 904b of the conductive adhesive layer 904 are disposed on and corresponding to the bonding pads 902 of the substrate 900. For example, in some embodiments, the number, location, and/or the arrangement of the conductive materials 904b of the conductive adhesive layer 904 may correspond to the number, location, and/or arrangement of the bonding pads 902 of the substrate 900. In some other embodiments, the number of conductive materials 904b of the conductive adhesive layer 904 may be less than the number of bonding pads 902 of the substrate 900. In some embodiments, in a top view, a conductive material 904b at least partially overlaps the corresponding bonding pad 902 thereof.

In some embodiments, since the conductive materials 904b are disposed on and corresponding to the bonding pads 902, there is no conductive materials between adjacent bonding pads 902, reducing the occurrence of short circuit.

For example, a conductive blanket layer (not shown in the figures) may be formed on the substrate 900 by a physical vapor deposition process (e.g., evaporation process or sputtering process), an electroplating process, an atomic layer deposition process, other applicable processes, or a combination thereof, and then a patterning process such as a lithography process and an etching process may be used to pattern the conductive blanket layer to form the conductive materials 904b on the bonding pads 902 of the substrate 900, and then a process such as a spin-on coating process may be used to form the non-conductive adhesive material 904a on the substrate 900 and the conductive materials 904b, such that the conductive adhesive layer 904 including the non-conductive adhesive material 904a and the conductive materials 904b is formed on the substrate 900.

Then, as shown in FIG. 9C, light-emitting diodes 906 are bonded to the substrate 900 through the conductive materials 904b of the conductive adhesive layer 904, and a curing process is performed to cure the non-conductive adhesive material 904a of the conductive adhesive layer 904, so as to form the display device 90 of the present embodiment. In some embodiments, the bonding process the same as or similar to those of the above embodiments may be performed to bond the conductive pads (e.g., the conductive pad 906c and the conductive pad 906d of the light-emitting diode 906, the conductive materials 904b, and the bonding pads 902. In some embodiments, the curing process the same as or similar to those of the above embodiments may be performed to cure the non-conductive adhesive material 904a.

In some embodiments, since the conducive materials 904b are disposed on and corresponding to the bonding pads 902, and the conductive pad 906c and the conductive pad 906d of the light-emitting diode 906 are also disposed on and corresponding to the conductive materials 904b, there is no conductive materials 904b between the conductive pad 906c and the conductive pad 906d adjacent to the conductive pad 906c of the light-emitting diode 906, and the occurrence of shot circuit may be reduced. In some other embodiments, there is at least one conductive material 904b between the conductive pad 906c and the conductive pad 906d adjacent to the conductive pad 906c of the light-emitting diode 906, but the at least one conductive material 904b is electrically floated with respect to the conductive pads 906c and 906d on the left side and right side of the at least one conductive material 904b, and thus the occurrence of short circuits may be avoided.

For example, the main portion 906m of the light-emitting diode 906 may be the same as or similar to the main portion 706m of the light-emitting diode 706 of the above embodiments, the conducive pads 906c and 906d of the light-emitting diode 906 may be the same as or similar to the conductive pads 706c and 706d of the light-emitting diode 706. In some embodiments, since the conductive materials 904b are also made of a metal having low melting point or a metal alloy having low eutectic point, the present embodiment also has the advantages (e.g., low manufacturing cost) the same as or similar to those of the above embodiments.

It should be understood that although the conductive adhesive layer 904 is formed on the substrate 900, and then the light-emitting diodes 906 are bonded to the substrate 900 through the conductive materials 904b in the embodiment discussed above, the present disclosure is not limited thereto. In some other embodiments, the light-emitting diodes 906 may be disposed on a substrate (not shown in the figures), and then the conductive materials 904b are disposed on and corresponding to the conductive pads 906c and the conductive pads 906d of the light-emitting diodes 906, and then the non-conductive adhesive material 904a is disposed on the substrate, the conductive pads 906c, the conductive pads 906d, and the conductive materials 904b corresponding to the conductive pads 906c and the conductive pads 906d, and then a bonding process may be performed to bond the light-emitting diodes 906 onto the substrate 900 through the conductive materials 904b, and a curing process may be performed to cure the non-conductive adhesive material 904a to form the display device 90.

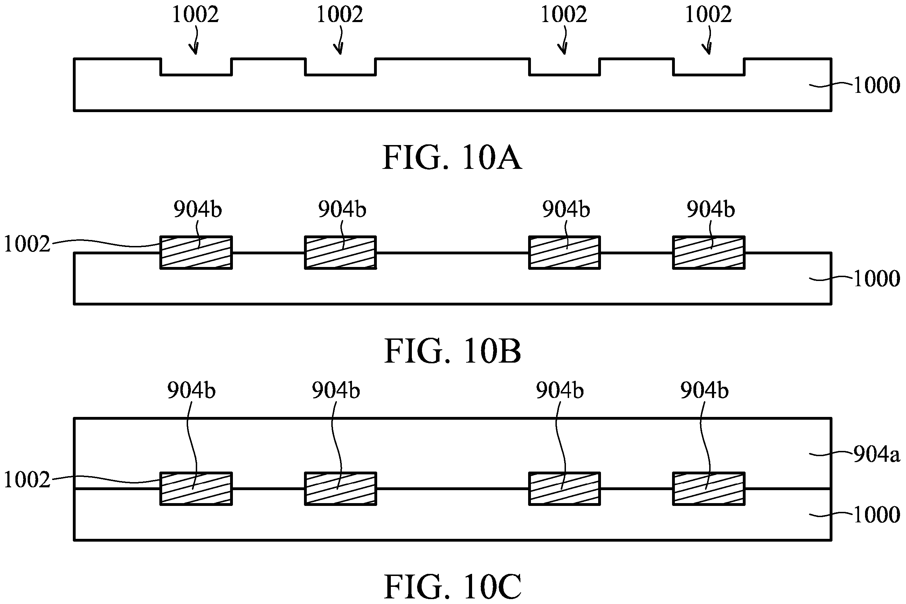

FIGS. 10A to 10F are a series of cross-sectional views illustrating some variations of the method for forming the display device 90 of the present example. It should be noted that, unless otherwise specified, the elements of the variation examples the same as or similar to those of the above examples will be denoted by the same reference numerals, and the forming methods thereof may be the same as or similar to those of the above examples.

First, as shown in FIG. 10A, a temporary substrate 1000 is provided. In some embodiments, as shown in FIG. 10A, a plurality of openings (or trenches) 1002 are provided in the temporary substrate 1000. In some embodiments, the location, number, and/or arrangement of the openings 1002 may correspond to the bonding pads 902 of the substrate 900, and/or the conductive pads 906c and 906d of the light-emitting diodes 906 disposed on the bonding pads 902 of the substrate 900.

For example, the temporary substrate 1000 may be made of polyimide, but the present disclosure is not limited thereto. For example, the openings 1002 may be formed in the temporary substrate 1000 by a lithography process, an etching process, a mechanical drilling process, a laser drilling process, other applicable processes, or a combination thereof, but the present disclosure is not limited thereto.

Then, as shown in FIG. 10B, the conductive materials 904b are formed in the openings 1002. In some embodiments, the location, number, and/or arrangement of the openings 1002 may correspond to the location, number, and/or arrangement of the bonding pads of the substrate of the display device, and/or may correspond to the location, number, and/or arrangement of the conductive pads of the light-emitting diodes disposed on the bonding pads of the substrate, and thus the location, number, and/or arrangement of the conductive materials 904b may also correspond to the location, number, and/or arrangement of the bonding pads of the substrate of the display device, and/or may correspond to the location, number, and/or arrangement of conductive pads of the light-emitting diodes disposed on the bonding pads of the substrate.

Then, as shown in FIG. 10C, the non-conductive adhesive material 904a is disposed on the temporary substrate 1000 to cover the conductive materials 904b.

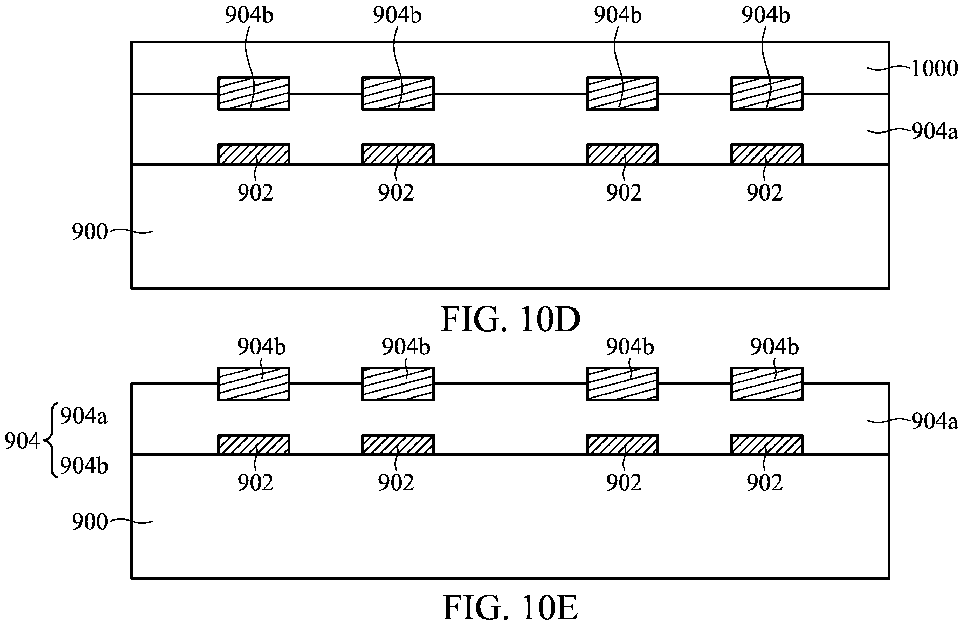

Then, as shown in FIG. 10D, the temporary substrate 1000 is flipped over, and the non-conductive adhesive material 904a is attached onto the substrate 900.

Then, as shown in FIG. 10E, the temporary substrate 1000 is removed. In some embodiments, an etching process or a laser process may be used to remove the temporary substrate 1000, but the present disclosure is not limited thereto.

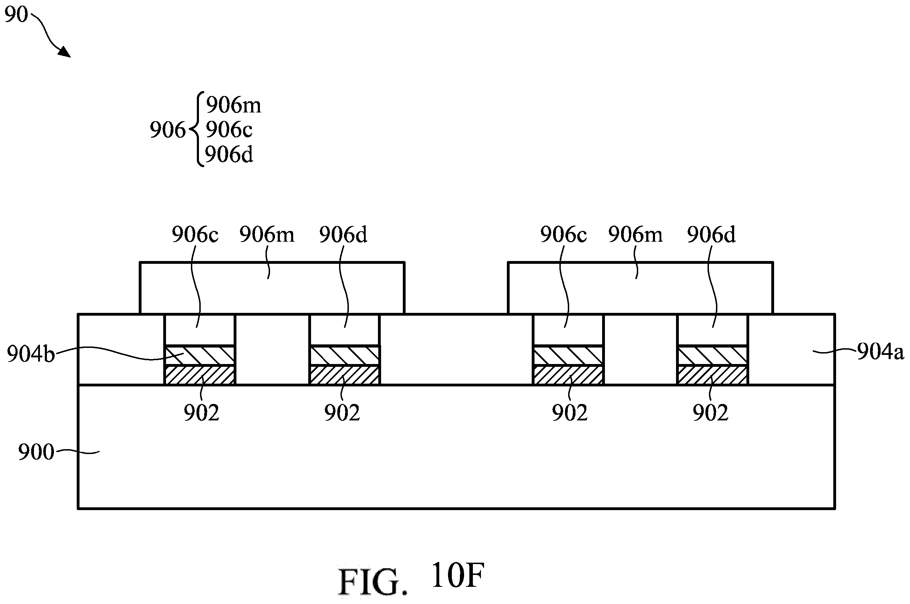

Then, as shown in FIG. 10F, in some embodiments, an attaching process is performed to attach the light-emitting diodes 906 onto the conductive materials 904b and to attach the conductive materials 904b onto the bonding pads 902. In some embodiments, the attaching process may include heating the non-conductive adhesive material 904a to an applicable temperature (e.g., in a range between 100°C and 250°C) to increase the flowability of the non-conductive adhesive material 904a. In some embodiments, the attaching process may include using a pick-up head (not shown in the figures) to grasp the light-emitting diodes 906 and move the light-emitting diodes 906 to be on the substrate 900, and then using the pick-up head to move the light-emitting diodes 906 toward the substrate 900, such that the conductive pads 906c and 906d of the light-emitting diodes 906 are in direct contact with the conductive materials 904b, and the conductive materials 904b are in direct contact with the bonding pads 902.

Still referring to FIG. 10F, a bonding process the same as or similar to those of the above embodiments may be performed to bond the light-emitting diodes 906 and the substrate 900 through the conductive materials 904b of the conductive adhesive layer 904, and a curing process may be performed to cure the non-conductive adhesive material 904a of the conductive adhesive layer 904 to form the display device 90 of the present embodiment.

In summary, the conductive materials of the conductive adhesive layer of the present embodiment are disposed corresponding to the bonding pads of the substrate of the display device and/or the conductive pads of the light-emitting diodes, and thus the occurrence of short circuits may be reduced.

The foregoing detailed description outlines features of several embodiments so that those skilled in the art may better understand the aspects of the present invention. Those skilled in the art should appreciate that they may readily use the detailed description as a basis for designing or modifying other processes and structures for carrying out the same purposes and/or achieving the same advantages of the embodiments introduced herein. Those skilled in the art should also realize that they may make various changes, substitutions, and alterations herein without departing from the scope of the present invention as defined by the appended claims.

## Claims

1. A display device (50), comprising:
a substrate (500);
a first light-emitting diode (102; 302) comprising:
a first conductive pad (102c; 302c);
a second conductive pad (102d; 302d) adjacent to the first conductive pad; and
a first light-emitting portion (102e; 302e) disposed on the first conductive pad; and
a second light-emitting diode (104) comprising:
a third conductive pad (104c);
a fourth conductive pad (104d) adjacent to the third conductive pad; and
a second light-emitting portion (104e) disposed on the third conductive pad, wherein a distance (D1) between the first conductive pad (102c; 302c) and the third conductive pad (104c) is less than a distance (D2) between the second conductive pad (102d; 302d) and the fourth conductive pad (104d), wherein the first light-emitting diode (102; 302) and the second light-emitting diode (104) are disposed corresponding to a pixel (P1) of the display device;
wherein the substrate (500) further comprises a plurality of bonding pad groups (100A, 100a, 100a'; 100B, 100b, 100b'; 100C, 100c, 100c') and a plurality of redundant bonding pad groups (500A, 500a, 500a'), wherein the bonding pad groups (100A, 100a, 100a'; 100B, 100b, 100b'; 100C, 100c, 100c') and the redundant bonding pad groups (500A, 500a, 500a') are disposed corresponding to the pixel (P1) of the display device;
wherein the first light-emitting diode (102; 302) is disposed on the substrate (500) and bonded to one of the bonding pad groups (100A, 100a, 100a');
wherein the second light-emitting diode (104) is disposed on the substrate (500) and bonded to another of the bonding pad groups (100B, 100b, 100b'); and
wherein at least one of the redundant bonding pad groups (500A, 500a, 500a') is not bonded with any light-emitting diode.

2. The display device as claimed in claim 1, wherein the first light-emitting portion (102e; 302e) emits a first light, the second light-emitting portion (104e) emits a second light, and the first light and the second light are the same color.

3. The display device as claimed in claim 1, wherein the first light-emitting portion (102e; 302e) emits a first light, the second light-emitting portion (104e) emits a second light, and the first light and the second light are different colors.

4. The display device as claimed in claim 1, wherein the substrate comprises a driving circuit, and the first light-emitting diode (102; 302) and the second light-emitting diode (104) are electrically connected to the driving circuit.

5. The display device as claimed in one of the claims 1-4, further comprising:
a third light-emitting diode (106), wherein the first light-emitting diode (102; 302), the second light-emitting diode (104), and the third light-emitting diode (106) are arranged in a triangle.

6. The display device as claimed in one of the claims 1-5, wherein the first light-emitting diode (302) further comprises:
a fifth conductive pad (302c), and
a third light-emitting portion (302e) disposed on the fifth conductive pad.

## Patentansprüche

1. Anzeigevorrichtung (50), umfassend:
ein Substrat (500);
eine erste lichtemittierende Diode (102; 302), umfassend:
eine erste leitende Kontaktfläche (102c; 302c);
eine zweite leitende Kontaktfläche (102d; 302d), die an die erste leitende Kontaktfläche angrenzt; und
einen ersten lichtemittierenden Abschnitt (102e; 302e), der auf der ersten leitenden Kontaktfläche angeordnet ist; und
eine zweite lichtemittierende Diode (104), umfassend:
eine dritte leitende Kontaktfläche (104c);
eine vierte leitende Kontaktfläche (104d), die an die dritte leitende Kontaktfläche angrenzt; und
einen zweiten lichtemittierenden Abschnitt (104e), der auf der dritten leitenden Kontaktfläche angeordnet ist, wobei ein Abstand (D1) zwischen der ersten leitenden Kontaktfläche (102c; 302c) und der dritten leitenden Kontaktfläche (104c) kleiner ist als ein Abstand (D2) zwischen der zweiten leitenden Kontaktfläche (102d; 302d) und der vierten leitenden Kontaktfläche (104d), wobei die erste lichtemittierende Diode (102; 302) und die zweite lichtemittierende Diode (104) entsprechend einem Pixel (P1) der Anzeigevorrichtung angeordnet sind;
wobei das Substrat (500) ferner eine Vielzahl von Bonding-Pad-Gruppen (100A, 100a, 100a'; 100B, 100b, 100b'; 100C, 100c, 100c') und eine Vielzahl von redundanten Bonding-Pad-Gruppen (500A, 500a, 500a') umfasst, wobei die Bonding-Pad-Gruppen (100A, 100a, 100a'; 100B, 100b, 100b'; 100C, 100c, 100c') und die redundanten Bonding-Pad-Gruppen (500A, 500a, 500a') entsprechend dem Pixel (P1) der Anzeigevorrichtung angeordnet sind;
wobei die erste lichtemittierende Diode (102; 302) auf dem Substrat (500) angeordnet ist und an einer der Bonding-Pad-Gruppen (100A, 100a, 100a') gebundet ist;
wobei die zweite lichtemittierende Diode (104) auf dem Substrat (500) angeordnet und an eine andere der Bonding-Pad-Gruppen (100B, 100b, 100b') gebondet ist; und
wobei mindestens eine der redundanten Bonding-Pad-Gruppen (500A, 500a, 500a') mit keiner lichtemittierenden Diode gebondet ist.

2. Anzeigevorrichtung nach Anspruch 1, wobei der erste lichtemittierende Abschnitt (102e; 302e) ein erstes Licht emittiert, der zweite lichtemittierende Abschnitt (104e) ein zweites Licht emittiert und das erste Licht und das zweite Licht die gleiche Farbe haben.

3. Anzeigevorrichtung nach Anspruch 1, wobei der erste lichtemittierende Abschnitt (102e; 302e) ein erstes Licht emittiert, der zweite lichtemittierende Abschnitt (104e) ein zweites Licht emittiert und das erste Licht und das zweite Licht unterschiedliche Farben haben.

4. Anzeigevorrichtung nach Anspruch 1, wobei das Substrat eine Treiberschaltung umfasst und die erste lichtemittierende Diode (102; 302) und die zweite lichtemittierende Diode (104) elektrisch mit der Treiberschaltung verbunden sind.

5. Anzeigevorrichtung nach einem der Ansprüche 1 bis 4, ferner umfassend eine dritte lichtemittierende Diode (106), wobei die erste lichtemittierende Diode Diode (102; 302), die zweite lichtemittierende Diode (104) und die dritte lichtemittierende Diode (106) in einem Dreieck angeordnet sind.

6. Anzeigevorrichtung nach einem der Ansprüche 1 bis 5, wobei die erste lichtemittierende Diode (302) ferner Folgendes umfasst:
eine fünftes leitfähige Kontaktfläche (302c), und
einen dritten lichtemittierenden Abschnitt (302e), der auf der fünften leitenden Kontaktfläche angeordnet ist.

## Revendications

1. Afficheur (50), comprenant:
un substrat (500);
une première diode électroluminescente (102; 302), comprenant:
une première surface de contact conductrice (102c; 302c);
une deuxième surface de contact conductrice (102d; 302d) adjacente à la première surface de contact conductrice; et
une première partie électroluminescente (102e; 302e) disposée sur la première surface de contact conductrice; et
une deuxième diode électroluminescente (104) comprenant:
une troisième surface de contact conductrice (104c);
une quatrième surface de contact conductrice (104d) adjacente à la troisième surface de contact conductrice; et
une deuxième partie électroluminescente (104e) disposée sur la troisième surface de contact conductrice, dans laquelle une distance (D1) entre la première surface de contact conductrice (102c; 302c) et la troisième surface de contact conductrice (104c) est inférieure à une distance (D2) entre la deuxième surface de contact conductrice (102d; 302d) et la quatrième surface de contact conductrice (104d), dans lequel la première diode électroluminescente (102; 302) et la deuxième diode électroluminescente (104) sont disposées en fonction d'un pixel (P1) du Afficheur;
dans lequel le substrat (500) comprend en outre une pluralité de groupes de plages de liaison (100A, 100a, 100a'; 100B, 100b, 100b'; 100C, 100c, 100c') et une pluralité de groupes de plages de liaison redondants (500A, 500a, 500a'), dans lequel les groupes de plages de liaison (100A, 100a, 100a'; 100B, 100b, 100b'; 100C, 100c, 100c') et les groupes de plages de liaison redondants (500A, 500a, 500a') sont disposés en fonction du pixel (P1) du Afficheur;
dans lequel la première diode électroluminescente (102 ; 302) est disposée sur le substrat (500) et est connectée à l'un des groupes de plages de connexion (100A, 100a, 100a');
la seconde diode électroluminescente (104) étant disposée sur le substrat (500) et étant connectée à un autre des groupes de plages de connexion (100B, 100b, 100b'); et
dans lequel au moins l'un des groupes de plages de liaison redondants (500A, 500a, 500a') n'est connecté à aucune diode électroluminescente.

2. Le afficheur selon la revendication 1, dans lequel la première partie électroluminescente (102e; 302e) émet une première lumière, la deuxième partie électroluminescente (104e) émet une deuxième lumière, et la première lumière et la deuxième lumière ont la même couleur.

3. Le afficheur selon la revendication 1, dans lequel la première partie électroluminescente (102e; 302e) émet une première lumière, la deuxième partie électroluminescente (104e) émet une deuxième lumière, et la première lumière et la deuxième lumière ont des couleurs différentes.

4. Le afficheur selon la revendication 1, dans lequel le substrat comprend un circuit de commande et la première diode électroluminescente (102; 302) et la deuxième diode électroluminescente (104) sont connectées électriquement au circuit de commande.

5. Le afficheur selon l'une quelconque des revendications 1 à 4, comprenant en outre
une troisième diode électroluminescente (106), la première diode électroluminescente (102; 302), dans lequel la deuxième diode électroluminescente (104) et la troisième diode électroluminescente (106) étant disposées en triangle.

6. Le afficheur selon l'une quelconque des revendications 1 à 5, dans lequel la première diode électroluminescente (302) comprend en outre:
une cinquième surface de contact conductrice (302c), et
une troisième partie électroluminescente (302e) disposée sur la cinquième surface de contact conductrice.
